(19)

Europäisches
Patentamt

European
Patent Office

Office européen
des brevets

(11)  **EP 2 544 243 A1**

(12)  # EUROPEAN PATENT APPLICATION
published in accordance with Art. 153(4) EPC

(43) Date of publication:
**09.01.2013 Bulletin 2013/02**

(21) Application number: **11750831.7**

(22) Date of filing: **04.03.2011**

(51) Int Cl.:
*H01L 31/04* (2006.01)    *B32B 3/30* (2006.01)
*B32B 27/00* (2006.01)    *B32B 27/30* (2006.01)

(86) International application number:
**PCT/JP2011/055118**

(87) International publication number:
**WO 2011/108722 (09.09.2011 Gazette 2011/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **05.03.2010  JP 2010049630**

(71) Applicants:
• **JX Nippon Oil & Energy Corporation
Chiyoda-ku
Tokyo 100-8162 (JP)**
• **Tokyo Institute of Technology
Tokyo 152-8550 (JP)**

(72) Inventors:
• **TAKEZOE Hideo
Tokyo 152-8550 (JP)**
• **KOO, Won Hoe
Tokyo 152-8550 (JP)**
• **NISHIMURA Suzushi
Yokohama-shi
Kanagawa 231-0815 (JP)**

• **SEKI Takashi
Yokohama-shi
Kanagawa 231-0815 (JP)**
• **TORIYAMA Shigetaka
Yokohama-shi
Kanagawa 231-0815 (JP)**
• **JEONG, Soon Moon
Yokohama-shi
Kanagawa 231-0815 (JP)**
• **FUKUDA Maki
Yokohama-shi
Kanagawa 231-0815 (JP)**
• **FUKUSHIMA Madoka
Yokohama-shi
Kanagawa 231-0815 (JP)**
• **MASUYAMA Satoshi
Yokohama-shi
Kanagawa 231-0815 (JP)**

(74) Representative: **HOFFMANN EITLE
Patent- und Rechtsanwälte
Arabellastrasse 4
81925 München (DE)**

(54)  **TRANSPARENT CONDUCTIVE SUBSTRATE FOR SOLAR CELL, METHOD FOR
MANUFACTURING THE SUBSTRATE, AND SOLAR CELL USING THE SUBSTRATE**

(57)     A transparent electroconductive substrate for a solar cell, comprising:
a transparent supporting substrate;
a transparent electroconductive layer; and
a cured resin layer placed between the transparent supporting substrate and the transparent electroconductive layer, wherein
concavities and convexities are formed on a surface of the cured resin layer, the surface facing the transparent electroconductive layer, and
when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu m^{-1}$, and the circular or annular pattern is present within a region where an absolute value of wavenumber is within a range from 0.5 to 10 $\mu m^{-1}$.

**(Cont. next page)**

EP 2 544 243 A1

Fig. 19

**Description**

[Technical Field]

The present invention relates to a transparent electroconductive substrate for a solar cell, a method for manufacturing the substrate, and a solar cell using the substrate.

[Background Art]

Solar cells have attracted attention as power generation systems utilizing natural light energy (clean energy) through conversion thereof to electric power. For example, solar cells using amorphous silicon as a photoelectric conversion layer have been put into practical use. Recently, various technologies for such solar cells have been studied in order to achieve a higher level of photoelectric conversion efficiency. As one of these technologies, for example, a technology is proposed with which the photoelectric conversion efficiency is improved by a transparent substrate for a solar cell provided with a shape of concavities and convexities and configured to exhibit a light confinement effect with the shape.
As such a transparent substrate for a solar cell, for example, International Publication No. WO2004/102677 (PTL 1) discloses a transparent electroconductive substrate in which a $TiO_2$ layer, a $SiO_2$ layer, and a $SnO_2$ layer are stacked on a base member in this order, and the $SnO_2$ layer is formed as a layer having concavities and convexities by a normal pressure CVD method. Moreover, Japanese Unexamined Patent Application Publication No. 2000-183378 (PTL 2) discloses a transparent substrate having a surface thereof formed into a shape of fine concavities and convexities by immersing a silicon substrate in an aqueous solution of sodium carbonate ($Na_2CO_3$) while the aqueous solution is used as an etchant. Further, Japanese Unexamined Patent Application Publication No. Hei 07-122764 (PTL 3) discloses a solar cell substrate in which at least a solar cell formation portion on a principal surface of a substrate forming a solar cell is made to have a shape of concavities and convexities by a sandblasting method, and a thin film having a thickness not larger than an average step height of the concavities and convexities is selectively formed on a bottom portion of the shape of the concavities and convexities. In the field of solar cells, for example, a technology of forming concavities and convexities on a power generation layer of a solar cell has also been studied, in addition to the technologies of forming concavities and convexities on a transparent substrate. Japanese Unexamined Patent Application Publication No. 2000-277763 (PTL 4) discloses an amorphous or microcrystalline solar cell in which a power generation layer is formed of a thin film having a shape of fine concavities and convexities. However, solar cells using conventional transparent substrates as described in PTLs 1 to 4 and the like are not necessarily sufficient in terms of photoelectric conversion efficiency.

[Citation List]

[Patent Literature]

[PTL 1] International Publication No. WO2004/102677
[PTL 2] Japanese Unexamined Patent Application Publication No. 2000-183378
[PTL 3] Japanese Unexamined Patent Application Publication No. Hei 07-122764
[PTL 4] Japanese Unexamined Patent Application Publication No. 2000-277763

[Summary of Invention]

[Technical Problem]

The present invention has been made in view of the problem of the above-described conventional technologies. An object of the present invention is to provide a transparent electroconductive substrate for a solar cell, the substrate being capable of exhibiting a sufficiently excellent light confinement effect, and of providing a sufficiently high level of photoelectric conversion efficiency to a solar cell when used as a transparent electroconductive substrate of a solar cell, as well as a method for manufacturing a transparent electroconductive substrate for a solar cell, the method being capable of efficiently manufacturing such a transparent electroconductive substrate for a solar cell, and a solar cell using the transparent electroconductive substrate.

[Solution to Problem]

The present inventors have conducted earnest study to achieve the above object. First, the present inventors have examined the reason why a sufficient photoelectric conversion efficiency cannot necessarily be obtained by the above-described conventional technologies. Here, the present inventors presumed that a sufficient photoelectric conversion efficiency cannot necessarily be obtained by a transparent electroconductive substrate as described in PTL 1 because of the following reason. Specifically, in this substrate, the shape of the concavities and convexities formed by a normal pressure CVD method and by use of a crystal surface of an inorganic oxide is acute, and the coatability of a semiconductor layer stacked thereon is poor. Hence, the film thickness of the semiconductor layer on the substrate is non-uniform, or portions where no semiconductor layer exists are formed, so that currents cannot be extracted through these portions. Meanwhile, the present inventors presumed that a sufficient photoelectric conversion efficiency cannot necessarily be obtained by a transparent substrate as described in PTL 2 because of the following reason, as in the above-described case. Specifically, in this substrate, a shape of concavities and convexities formed on a crystal surface by an etching method is used, and hence the coatability is poor when a semiconductor layer or the like is stacked. Moreover, the present inventors presumed that a sufficient photoelectric conversion efficiency cannot necessarily be obtained by a solar cell substrate as described in PTL 3 because of the following reason. Specifically, in the case of this substrate, a shape of concavities and convexities is formed by a sandblasting method, and hence a shape of fine concavities and convexities cannot be formed. Accordingly, a sufficient diffraction effect cannot be obtained from this shape of the concavities and convexities, so that a sufficient light confinement effect cannot be obtained. Further, the present inventors presumed that a sufficient photoelectric conversion efficiency cannot necessarily be obtained also by an amorphous or microcrystalline solar cell in which a power generation layer is formed of a thin film having a shape of fine concavities and convexities as described in PTL 4 because of the following reason. Specifically, in this solar cell, the shape of the concavities and convexities of the thin film is steeply protruded. Hence, leakage is prone to occur at the steeply protruded portions, and moreover a sufficient light confinement effect cannot necessarily be obtained by the formed shape of the concavities and convexities.

Based on these examination results, the present inventors have further conducted earnest study to achieve the above object. As a result, the present inventors have found that sufficiently efficient photoelectric conversion can be carried out by the following transparent electroconductive substrate for a solar cell, even when an incident angle of sunlight changes. Specifically, this transparent electroconductive substrate for a solar cell comprises a transparent supporting substrate and a transparent electroconductive layer, wherein a cured resin layer having a shape of concavities convexities on a surface thereof is placed between the transparent supporting substrate and the transparent electroconductive layer, and the shape of the concavities and convexities is formed such that when a Fourier-transformed image is obtained by performing two-dimensional fast Fourier transform processing on a concavity and convexity analysis image obtained by analyzing the shape of the concavities and convexities by use of an atomic force microscope analysis, the Fourier-transformed image forms a circular or annular pattern substantially centered at an origin at which an absolute value of wavenumber is 0 $\mu$m$^{-1}$. In addition, the present inventors have also found that light can be efficiently absorbed by a semiconductor layer of a solar cell, a sufficiently excellent light confinement effect can be exhibited, and a sufficiently high level of photoelectric conversion efficiency can be provided to the solar cell, when the shape of the concavities and convexities is formed such that the circular or annular pattern of the Fourier-transformed image can be present within a region where an absolute value of wavenumber is within a range from 0.5 to 10 $\mu$m$^{-1}$. These findings have led to the completion of the present invention.

Specifically, a transparent electroconductive substrate for a solar cell of the present invention comprises:

    a transparent supporting substrate;
    a transparent electroconductive layer; and
    a cured resin layer placed between the transparent supporting substrate and the transparent electroconductive layer, wherein
    concavities and convexities are formed on a surface of the cured resin layer, the surface facing the transparent electroconductive layer, and
    when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu$m$^{-1}$, and the circular or annular pattern is present within a region where an absolute value of wavenumber is within a range from 0.5 to 10 $\mu$m$^{-1}$.

In the transparent electroconductive substrate for a solar cell of the present invention, an average height of the concavities and convexities formed on the surface of the cured resin layer, the surface facing the transparent electroconductive layer, is preferably 5 to 200 nm. In addition, in the transparent electroconductive substrate for a solar cell of the present invention, an average pitch of the concavities and convexities formed on the surface of the cured resin layer, the surface facing the transparent electroconductive layer, is preferably within a range from 100 to 2000 nm.

Moreover, in the transparent electroconductive substrate for a solar cell of the present invention, the cured resin layer is preferably made of an acrylic resin.

A method for manufacturing a transparent electroconductive substrate for a solar cell of the present invention comprises the steps of:

applying a curable resin onto a transparent supporting substrate, then curing the curable resin with a master block being pressed thereto, and thereafter detaching the master block, thereby stacking, on the transparent supporting substrate, a cured resin layer having concavities and convexities formed thereon; and

stacking, on the cured resin layer, a transparent electroconductive layer having such a shape that the shape of the concavities and convexities formed on a surface of the cured resin layer is maintained, thereby obtaining a transparent electroconductive substrate for a solar cell, the transparent electroconductive substrate comprising the transparent supporting substrate, the cured resin layer, and the transparent electroconductive layer, wherein

the master block is obtained by a method comprising the steps of:

applying a block copolymer solution comprising a block copolymer and a solvent onto a base member, the block copolymer having a first polymer segment made of a first homopolymer and a second polymer segment made of a second homopolymer having a solubility parameter which is higher than a solubility parameter of the first homopolymer by 0.1 to 10 $(cal/cm^3)^{1/2}$, and satisfying all the following requirements (i) to (iii):

(i) a number average molecular weight is 500000 or more,
(ii) a molecular weight distribution (Mw/Mn) is 1.5 or less, and
(iii) a volume ratio between the first polymer segment and the second polymer segment (the first polymer segment:the second polymer segment) is 3:7 to 7:3; and

forming a micro phase separation structure of the block copolymer by drying a coating film on the base member, thereby obtaining a first master block having concavities and convexities formed on a surface thereof.

In the method for manufacturing a transparent electroconductive substrate for a solar cell of the present invention, the dried coating film is preferably heated at a temperature higher than a glass transition temperature of the block copolymer, in the step of obtaining the first master block.

Moreover, in the method for manufacturing a transparent electroconductive substrate for a solar cell of the present invention, the dried coating film is preferably subjected to an etching treatment, in the step of obtaining the first master block.

Moreover, the method for manufacturing a transparent electroconductive substrate for a solar cell of the present invention preferably further comprises a step of attaching a transfer material onto the first master block, then curing the transfer material, and thereafter detaching the transfer material from the first master block, thereby obtaining a second master block having concavities and convexities formed on a surface thereof.

Moreover, in the method for manufacturing a transparent electroconductive substrate for a solar cell of the present invention, a combination of the first homopolymer and the second homopolymer in the block copolymer is preferably any of a combination of a styrene-based polymer and a polyalkyl methacrylate, a combination of a styrene-based polymer and polyethylene oxide, a combination of a styrene-based polymer and polyisoprene, and a combination of a styrene-based polymer and polybutadiene.

In addition, in the method for manufacturing a transparent electroconductive substrate for a solar cell of the present invention, the block copolymer solution preferably further comprises a different homopolymer from the first homopolymer and the second homopolymer in the block copolymer, and it is further preferable that the combination of the first homopolymer and the second homopolymer in the block copolymer be a combination of polystyrene and polymethyl methacrylate, and the different homopolymer be a polyalkylene oxide.

Further, a solar cell of the present invention comprises:

a transparent electroconductive substrate;
a counter electrode electroconductive layer; and
a semiconductor layer placed between the transparent electroconductive substrate and the counter electrode electroconductive layer, wherein
the transparent electroconductive substrate comprises:
a transparent supporting substrate;
a transparent electroconductive layer; and
a cured resin layer placed between the transparent supporting substrate and the transparent electroconductive layer,

concavities and convexities are formed on a surface of the cured resin layer, the surface facing the transparent electroconductive layer, and

when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu$m$^{-1}$, and the circular or annular pattern is present within a region where an absolute value of wavenumber is within a range from 0.5 to 10 $\mu$m$^{-1}$.

In the solar cell of the present invention, an average height of the concavities and convexities formed on the surface of the cured resin layer, the surface facing the transparent electroconductive layer, is preferably 5 to 200 nm.

In the solar cell of the present invention, an average pitch of the concavities and convexities formed on the surface of the cured resin layer, the surface facing the transparent electroconductive layer, is preferably within a range from 100 to 2000 nm.

Moreover, in the transparent electroconductive substrate for a solar cell of the present invention, the cured resin layer is preferably made of an acrylic resin.

Note that although it is not exactly clear why the above-describedobjectisachieved by the present invention, the present inventors speculate as follows. Specifically, first, in the present invention, the shape of the concavities and convexities of the cured resin layer is assumed to be such that when a Fourier-transformed image is obtained by performing two-dimensional fast Fourier transform processing on a concavity and convexity analysis image obtained by analyzing the shape of the concavities and convexities by use of an atomic force microscope, the Fourier-transformed image shows a circular or annular pattern substantially centered at an origin at which an absolute value of wavenumber is 0 $\mu$m$^{-1}$. Such a shape of the concavities and convexities whose Fourier-transformed image shows a circular or annular pattern substantially centered at an origin at which an absolute value of wavenumber is 0 $\mu$m$^{-1}$ can be said to be an isotropic shape of concavities and convexities in any cross-sectional direction. Since the shape of the concavities and convexities in the present invention is isotropic in any cross-sectional direction as described above, incidence of light can be sufficiently stable, and moreover a sufficiently high light confinement effect can be exhibited, irrespective of the incident angle of the incident light. For this reason, when the transparent electroconductive substrate for a solar cell of the present invention is used as a transparent electroconductive substrate of a solar cell, the lowering of performance due to movement of the sun (change in incident angle of the light) is sufficiently suppressed. Presumably because of this, the photoelectric conversion efficiency of the solar cell can be sufficiently improved. Moreover, the relationship between the pitch of the shape of the concavities and convexities (represented as a distance from the center in the Fourier-transformed image) and the wavelength of the incident light is examined based on the Raman-Nath diffraction theory expressed by the following formula (1) :

$$n_i \cdot \sin\theta_i - n_o \cdot \sin\theta_o = m \times (\lambda/d) \quad (1)$$

[in the formula (1), d represents the pitch of concavities and convexities, $\lambda$ represents a wavelength of incident light, $n_i$ represents a refractive index of a medium through which the light passes, $n_o$ represents a refractive index of a semiconductor, $\theta_i$ represents a light incident angle, $\theta_o$ represents a light exit angle, and m represents a diffraction order (0, $\pm$1, $\pm$2, ...)].

In a solar cell, it is preferable that light with any incident angle $\theta_i$ be diffracted, and the diffracted light be effectively taken into the film. Hence, it can be said that a greater exit angle $\theta_o$ is preferable. For example, suppose a case where a transparent substrate with a refractive index ($n_i$) of 1.5 and a semiconductor made of Si with a refractive index ($n_o$) of approximately 3.8 are used in a solar cell. Here, examination is made as to how to cause diffraction with a highest possible angle $\theta_o$ for all $\theta_i$ in a case where the order m is 1 with which the diffraction intensity is high. It can be seen that light can be diffracted with a highest value (angle) of $\theta_o$, when the pitch d is 43% of $\lambda$. Meanwhile, light absorbable by the solar cell is light with wavelengths shorter than the wavelength corresponding to the band gap of the semiconductor used. For this reason, it can be understood that, in order to confine light in the semiconductor by sufficiently diffracting the light, and perform efficient photoelectric conversion in a case where Si is used as a material of the semiconductor layer, it is effective to use light having a wavelength $\lambda$ of 1.12 $\mu$m, and set the pitch length of the concavities and convexities to a length not more than 0.49 $\mu$m (2.04 $\mu$m$^{-1}$ in terms of wavenumber of light), which is equal to 43% of the wavelength $\lambda$, because the band gap of Si is approximately 1.1 eV, and light with a wavelength having the same energy as the band gap is light with a wavelength of 1.12 $\mu$m. In addition to such a viewpoint, considering that the refractive index of a semiconductor layer made of an ordinary semiconductor material is about 3 to 4, and that the band gap of an ordinary semiconductor material is within a range from 3.4 eV (GaN) to 0.7 eV (Ge), it can be understood that wavenumbers of light for which the concavities and convexities in a solar cell can sufficiently exhibit a light confinement effect, and which can be efficiently absorbed in the semiconductor layer are 0.94 $\mu m^{-1}$ to 6.8 $\mu m^{-1}$. For this reason, it can be understood that, when the shape of the concavities and convexities is formed such that the distance (wavenumber) from the center in the Fourier-transformed image can be a value not smaller than a highest value which is equal to a wavenumber of light efficiently absorbable in the semiconductor layer, light can be absorbed sufficiently in the semiconductor layer, and a sufficiently high level of photoelectric conversion efficiency can be achieved. Accordingly, in the present invention, light can be efficiently absorbed by the solar cell, and an extremely excellent light confinement effect can be exhibited by the solar cell, when the shape of the concavities and convexities of the cured resin layer is formed, such that the pattern in the Fourier-transformed image of the shape of the concavities and convexities of the cured resin layer can be circular or annular, and the Fourier-transformed image can have a distance (wavenumber) within a range from 0.5 to 10 $\mu m^{-1}$ from the center. The present inventors presume that the photoelectric conversion efficiency of the solar cell is sufficiently improved because of these reasons.

In addition, it is difficult to form a shape of fine concavities and convexities with a desired pitch and in a well-controlled manner by any of the conventional methods for forming a shape of concavities and convexities as described in PTLs 1 to 3, where a normal pressure CVD method (a method utilizing a crystal surface), a method of etching a film, a method utilizing sandblasting, or the like is used. In addition, since the transparent electroconductive layers generally contain a metal oxide such as SnO or ZnO, it is difficult to process these transparent electroconductive layers. On the other hand, in the method for manufacturing a transparent electroconductive substrate for a solar cell of the present invention, the master block is formed as described above, and then a shape of concavities and convexities originated from a master block is precisely formed on a cured resin layer by pressing (placing a stamp with) the shape of the concavities and convexities of the master block. Hence, a specific shape of concavities and convexities can be formed relatively easily and highly reproducibly, and the transparent electroconductive substrate for a solar cell of the present invention can be manufactured efficiently. In particular, when an acrylic-based resin which is preferable as the curable resin (a material of the cured resin layer) is used, a shape of concavities and convexities originated from the master block can be formed more precisely, and a transparent electroconductive substrate for a solar cell can also be manufactured more easily and more rapidly. The present inventors presume that a transparent electroconductive substrate for a solar cell can be manufactured efficiently by the present invention because of these reasons.

[Advantageous Effects of Invention]

According to the present invention, it is possible to provide a transparent electroconductive substrate for a solar cell, the substrate being capable of exhibiting a sufficiently excellent light confinement effect, and of providing a sufficiently high level of photoelectric conversion efficiency to a solar cell, when used as a transparent electroconductive substrate of a solar cell, as well as a method for manufacturing a transparent electroconductive substrate for a solar cell, the method being capable of efficiently manufacturing such a transparent electroconductive substrate for a solar cell, and a solar cell using the transparent electroconductive substrate.

[Brief Description of Drawings]

[Fig. 1] Fig. 1 is a vertical cross-sectional view schematically showing a preferred embodiment of a transparent electroconductive substrate for a solar cell of the present invention.

[Fig. 2] Fig. 2 is a vertical cross-sectional view schematically showing a state where a curable resin is applied onto a transparent supporting substrate.

[Fig. 3] Fig. 3 is a vertical cross-sectional view schematically showing a state where the curable resin is cured with a master block being pressed thereto.

[Fig. 4] Fig. 4 is a vertical cross-sectional view schematically showing a state where concavities and convexities are formed on a surface of the cured resin layer by detaching the master block.

[Fig. 5] Fig. 5 is a vertical cross-sectional view schematically showing a state where a block copolymer solution is applied onto a base member.

[Fig. 6] Fig. 6 is a vertical cross-sectional view schematically showing a state where concavities and convexities are formed on a surface of a coating film by forming a micro phase separation structure of the block copolymer.

[Fig. 7] Fig. 7 is a vertical cross-sectional view schematically showing a state where a transfer material is attached onto a first master block.

[Fig. 8] Fig. 8 is a vertical cross-sectional view schematically showing a state where a cured second master block is detached from the first master block.

[Fig. 9] Fig. 9 is a photograph showing a concavity and convexity analysis image, in which a result of analysis conducted on a surface of First Master Block (M-1) obtained in Example 1 by use of a scanning probe microscope is displayed on a display.

[Fig. 10] Fig. 10 is a photograph showing a cross-sectional concavity and convexity analysis image, in which a result of analysis conducted on a cross-section of First Master Block (M-1) obtained in Example 1 by use of a scanning probe microscope is displayed on a display.

[Fig. 11] Fig. 11 is a photograph showing a Fourier-transformed image, in which a result of two-dimensional fast Fourier transform processing conducted on the concavity and convexity analysis image, which was obtained by use of an atomic force microscope, of the surface of First Master Block (M-1) obtained in Example 1 is displayed on a display.

[Fig. 12] Fig. 12 is a photograph showing a concavity and convexity analysis image, in which a result of analysis conducted on a surface of First Master Block (M-2) obtained in Example 1 after an etching treatment by use of a scanning probe microscope is displayed on a display.

[Fig. 13] Fig. 13 is a photograph showing a cross-sectional concavity and convexity analysis image, in which a result of analysis conducted on a cross-section of First Master Block (M-2) obtained in Example 1 after the etching treatment by use of a scanning probe microscope is displayed on a display.

[Fig. 14] Fig. 14 is a photograph showing a concavity and convexity analysis image, in which a result of analysis conducted on a surface of Second Master Block (M-3) obtained in Example 1 by use of a scanning probe microscope is displayed on a display.

[Fig. 15] Fig. 15 is a photograph showing a cross-sectional concavity and convexity analysis image, in which a result of analysis conducted on a cross-section of Second Master Block (M-3) obtained in Example 1 by use of a scanning probe microscope is displayed on a display.

[Fig. 16] Fig. 16 is a photograph showing a Fourier-transformed image, in which a result of two-dimensional fast Fourier transform processing conducted on the concavity and convexity analysis image, which was obtained by use of an atomic force microscope, of the surface of Second Master Block (M-3) obtained in Example 1 is displayed on a display.

[Fig. 17] Fig. 17 is a photograph showing a concavity and convexity analysis image, in which a result of analysis conducted on a surface of a cured resin layer formed in Example 1 by use of a scanning probe microscope is displayed on a display.

[Fig. 18] Fig. 18 is a photograph showing a cross-sectional concavity and convexity analysis image, in which a result of analysis conducted on a surface of the cured resin layer formed in Example 1 by use of a scanning probe microscope is displayed on a display.

[Fig. 19] Fig. 19 is a photograph showing a Fourier-transformed image, in which a result of two-dimensional fast Fourier transform processing conducted on the concavity and convexity analysis image, which was obtained by use of an atomic force microscope, of the surface of the cured resin layer formed in Example 1 is displayed on a display.

[Fig. 20] Fig. 20 is a photograph showing a concavity and convexity analysis image, in which a result of analysis conducted on a surface of a cured resin layer formed in Example 2 by use of a scanning probe microscope is displayed on a display.

[Fig. 21] Fig. 21 is a photograph showing a concavity and convexity analysis image, in which a result of analysis conducted on the surface of the cured resin layer formed in Example 2 by use of a scanning probe microscope is displayed on a display.

[Fig. 22] Fig. 22 is a photograph showing a cross-sectional concavity and convexity analysis image, in which a result of analysis conducted on a surface of the cured resin layer formed in Example 2 by use of a scanning probe microscope is displayed on a display.

[Fig. 23] Fig. 23 is a photograph showing a Fourier-transformed image, in which a result of two-dimensional fast Fourier transform processing conducted on the concavity and convexity analysis image, which was obtained by use of an atomic force microscope, of the surface of the cured resin layer formed in Example 2 is displayed on a display.

[Fig. 24] Fig. 24 is a photograph showing a concavity and convexity analysis image, in which a result of analysis conducted on a surface of First Master Block (M-9) obtained in Example 3 by use of a scanning probe microscope is displayed on a display.

[Fig. 25] Fig. 25 is a photograph showing a cross-sectional concavity and convexity analysis image, in which a result of analysis conducted on a cross-section of Second Master Block (M-9) obtained in Example 3 by use of a scanning probe microscope is displayed on a display.

[Fig. 26] Fig. 26 is a photograph showing a Fourier-transformed image, in which a result of two-dimensional fast Fourier transform processing conducted on a concavity and convexity analysis image, which was obtained by use of an atomic force microscope, of a surface of Second Master Block (M-9) obtained in Example 3 is displayed on a display.

[Fig. 27] Fig. 27 is a photograph showing a concavity and convexity analysis image, in which a result of analysis conducted on a surface of a cured resin layer formed in Example 3 by use of a scanning probe microscope is displayed on a display.

[Fig. 28] Fig. 28 is a photograph showing a concavity and convexity analysis image, in which a result of analysis conducted on the surface of the cured resin layer formed in Example 3 by use of a scanning probe microscope is displayed on a display.

[Fig. 29] Fig. 29 is a photograph showing a cross-sectional concavity and convexity analysis image, in which a result of analysis conducted on a surface of the cured resin layer formed in Example 3 by use of a scanning probe microscope is displayed on a display.

[Fig. 30] Fig. 30 is a photograph showing a Fourier-transformed image, in which a result of two-dimensional fast Fourier transform processing conducted on the concavity and convexity analysis image, which was obtained by use of an atomic force microscope, of the surface of the cured resin layer formed in Example 3 is displayed on a display.

[Fig. 31] Fig. 31 is a photograph showing a concavity and convexity analysis image, in which a result of analysis conducted on a surface of First Master Block (M-11) obtained in Example 4 after an etching treatment by use of a scanning probe microscope is displayed on a display.

[Fig. 32] Fig. 32 is a photograph showing a concavity and convexity analysis image, in which a result of analysis conducted on the surface of First Master Block (M-11) obtained in Example 4 after the etching treatment by use of a scanning probe microscope is displayed on a display.

[Fig. 33] Fig. 33 is a photograph showing a cross-sectional concavity and convexity analysis image, in which a result of analysis conducted on a surface of First Master Block (M-11) obtained in Example 4 after the etching treatment by use of a scanning probe microscope is displayed on a display.

[Fig. 34] Fig. 34 is a photograph showing a Fourier-transformed image, in which a result of two-dimensional fast Fourier transform processing conducted on the concavity and convexity analysis image, which was obtained by use of an atomic force microscope, of the surface of First Master Block (M-11) obtained in Example 4 after the etching treatment is displayed on a display.

[Fig. 35] Fig. 35 is a photograph showing a concavity and convexity analysis image, in which a result of analysis conducted on a surface of a cured resin layer formed in Example 4 by use of a scanning probe microscope is displayed on a display.

[Fig. 36] Fig. 36 is a photograph showing a concavity and convexity analysis image, in which a result of analysis conducted on the surface of the cured resin layer formed in Example 4 by use of a scanning probe microscope is displayed on a display.

[Fig. 37] Fig. 37 is a photograph showing a cross-sectional concavity and convexity analysis image, in which a result of analysis conducted on a surface of the cured resin layer formed in Example 4 by use of a scanning probe microscope is displayed on a display.

[Fig. 38] Fig. 38 is a photograph showing a Fourier-transformed image, in which a result of two-dimensional fast Fourier transform processing conducted on the concavity and convexity analysis image, which was obtained by use of an atomic force microscope, of the surface of the cured resin layer formed in Example 4 is displayed on a display.

[Fig. 39] Fig. 39 is a photograph showing a concavity and convexity analysis image, in which a result of analysis conducted on a surface of a cured resin layer formed in Example 5 by use of a scanning probe microscope is displayed on a display.

[Fig. 40] Fig. 40 is a photograph showing a cross-sectional concavity and convexity analysis image, in which a result of analysis conducted on a surface of the cured resin layer formed in Example 5 by use of a scanning probe microscope is displayed on a display.

[Fig. 41] Fig. 41 is a photograph showing a Fourier-transformed image, in which a result of two-dimensional fast Fourier transform processing conducted on the concavity and convexity analysis image, which was obtained by use of an atomic force microscope, of the surface of the cured resin layer formed in Example 5 is displayed on a display.

[Description of Embodiments]

Hereinafter, preferred embodiments of the present invention will be described in detail with reference to the drawings. Note that, in the following description and drawings, the same or corresponding components are denoted by the same reference numerals, and overlapping description thereof is omitted.

First, a transparent electroconductive substrate for a solar cell of the present invention is described. Specifically, the transparent electroconductive substrate for a solar cell of the present invention comprises:

a transparent supporting substrate;
a transparent electroconductive layer; and
a cured resin layer placed between the transparent supporting substrate and the transparent electroconductive layer, wherein
concavities and convexities are formed on a surface of the cured resin layer, the surface facing the transparent electroconductive layer,

when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu m^{-1}$, and the circular or annular pattern is present within a region where an absolute value of wavenumber is within a range from 0.5 to 10 $\mu m^{-1}$.

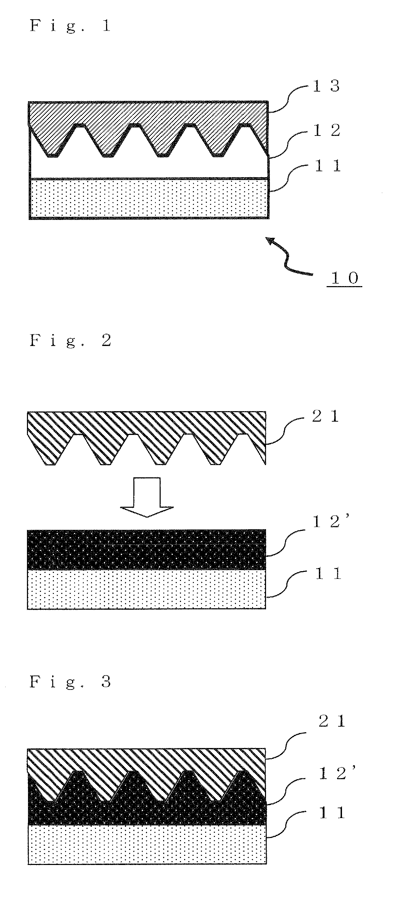

Fig. 1 shows a vertical cross-sectional view schematically showing a preferred embodiment of a transparent electroconductive substrate for a solar cell of the present invention. The transparent electroconductive substrate 10 for a solar cell shown in Fig. 1 comprises: a transparent supporting substrate 11; a cured resin layer 12 which is stacked on the transparent supporting substrate 11 and which has concavities and convexities formed on a surface thereof; and a transparent electroconductive layer 13 staked on the cured resin layer 12.

The transparent supporting substrate 11 is not particularly limited, as long as the transparent supporting substrate 11 is a transparent supporting substrate usable for a solar cell. As the transparent supporting substrate 11, a known transparent supporting substrate can be used as appropriate. Examples of the transparent supporting substrate 11 include substrates made of glass, silica glass, or the like. A thickness of the transparent supporting substrate 11 may be any, as long as the transparent supporting substrate 11 with the thickness can be used as a substrate for supporting a transparent electrode of a solar cell, and may be 0.1 to 5 mm, for example. In addition, a shape of the transparent supporting substrate 11 is not particularly limited, and may be changed as appropriate depending on an intended design of a solar cell.

The cured resin layer 12 is a layer made of a cured resin, and is a layer having concavities and convexities formed on a surface facing the transparent electroconductive layer 13 (a surface on a side where the transparent electroconductive layer 13 is stacked). Examples of the cured resin include epoxy resins, acrylic resins, urethane resins, melamine resins, urea resins, polyester resins, phenol resins, cross-linking-type liquid crystal resins, and silicone resins (resins having main skeletons of siloxane bonds). An acrylic resin is preferably used as the cured resin, from the viewpoints that the shape of the concavities and convexities is more efficiently formed, and that a material of a solar cell needs to have heat resistance because the temperature for a solar cell formation process is a relatively high temperature around 200°C. Note that particularly when the transparent electroconductive substrate for a solar cell is exposed to a high temperature in manufacturing a solar cell, the shape of the concavities and convexities according to the present invention may be formed, for example, by using the silicone resin particularly excellent in heat resistance as the cured resin, or by etching a heat resistant substrate such as glass or silica glass by using the cured resin as an etching mask.

A thickness of the cured resin layer 12 is preferably within a range from 0.5 to 500 $\mu m$. If the thickness of the cured resin layer 12 is less than the lower limit, heights of the concavities and convexities formed on the surface of the cured resin layer tend to be insufficient. Meanwhile, if the thickness exceeds the upper limit, an effect of volume change of the resin which occurs upon curing tends to be so large that the formation of the shape of the concavities and convexities tends to be poor.

Moreover, the cured resin layer 12 needs to be such that, when a Fourier-transformed image is obtained by performing two-dimensional fast Fourier transform processing on a concavity and convexity analysis image obtained by analyzing the shape of the concavities and convexities formed on the surface of the cured resin layer 12 by use of an atomic force microscope, the Fourier-transformed image shows a circular or annular pattern substantially centered at an origin at which an absolute value of wavenumber is 0 $\mu m^{-1}$, and the circular or annular pattern is present within a region where an absolute value of wavenumber is within a range from 0.5 to 10 $\mu m^{-1}$. By forming the shape of the concavities and convexities on the surface of the cured resin layer under the condition that the Fourier-transformed image can satisfy the above-described requirements, an excellent light diffraction effect can be obtained with a sufficiently low wavelength dependence and a sufficiently low directivity. Hence, when this is used for a solar cell, a higher level of light confinement effect can be obtained. Moreover, if the absolute value of wavenumber is out of the above-described range, it is difficult to manufacture a solar cell having sufficiently high photoelectric conversion efficiency in a case where a semiconductor layer for a solar cell is formed by using a semiconductor material having a band gap within a range from 3.4 eV (GaN) to 0.7 eV (Ge). Here, the phrase "the circular or annular pattern is present within a region where an absolute value of wavenumber is within a range from 0.5 to 10 $\mu m^{-1}$" means that 30% or more (more preferably 50% or more, further more preferably 80% or more, and particularly preferably 90% or more) of bright spots constituting the circular or annular pattern in the Fourier-transformed image are present within a region where an absolute value of wavenumber is within a range from 0.5 to 10 $\mu m^{-1}$. Moreover, the circular or annular pattern is a pattern observed when bright spots gather in a Fourier-transformed image. Hence, the term "circular" herein means that the pattern of the gathering of the bright spots looks like a substantially circular shape, and is a concept also including a case where a part of a contour thereof looks like a convex shape or a concave shape. Meanwhile, the term "annular" means that the pattern of the gathering of the bright spots looks like a substantially annular shape, and is a concept also including a case where a shape of an outer circle or inner circle of the ring looks like a substantially circular shape, and further including a case where a part of the contour of the outer circle or the inner circle of the ring looks like a convex shape or a concave shape. Note that such a shape of the concavities and convexities on the surface of the cured resin layer 12 can be formed efficiently by employing a method using a master block, according to the present invention to be described later.

In addition, the circular or annular pattern needs to be present within a region where an absolute value of wavenumber is within a range from 0.5 to 10 $\mu m^{-1}$, and is more preferably present within a region where an absolute value of wavenumber is within a range from 0.9 to 10 $\mu m^{-1}$, from the viewpoints of diffraction efficiency for wavelengths of sunlight, refractive indices of a semiconductor and a substrate used for a solar cell, and a band gap of the semiconductor. Moreover, the pattern of the Fourier-transformed image is more preferably annular, from the viewpoint of obtaining an isotropic diffraction effect, irrespective of the incident angle of sunlight.

In addition, the Fourier-transformed image can be obtained by analyzing the shape of the concavities and convexities formed on the surface of the cured resin layer 12 by use of an atomic force microscope, thereby obtaining a concavity and convexity analysis image, and then performing two-dimensional fast Fourier transform processing on the concavity and convexity analysis image. The concavity and convexity analysis image can be obtained by analysis using an atomic force microscope and employing the following analysis conditions:

Measurement mode: cantilever intermittent contact mode
Material of cantilever: silicon
Lever width of cantilever: 40 $\mu m$
Diameter of tip of cantilever chip: 10 nm.

In addition, as the atomic force microscope, commercially available ones can be used as appropriate. For example, a scanning probe microscope equipped with an environment control unit "Nanonavi II Station/E-sweep" manufactured by SII NanoTechnology Inc. can be used. In addition, it is preferable to employ a cantilever intermittent contact mode as the measurement mode of the atomic force microscope. When the scanning probe microscope equipped with the environment control unit manufactured by SII NanoTechnology Inc. is used, the dynamic force mode (DMF mode) may be used. Moreover, as the cantilever, one whose material is silicon, lever width is 40 $\mu m$, and diameter of a tip of a chip is 10 nm may be used, as described above. For example, SI-DF40maybeused. In addition, when the analysis is conducted by use of the atomic force microscope, it is preferable to observe the shape of the concavities and convexities formed on the surface of the cured resin layer in the air at a temperature of 25°C.

The two-dimensional fast Fourier transform processing on the concavity and convexity analysis image can be easily performed by electronic image processing using a computer equipped with software for two-dimensional fast Fourier transform processing. In the two-dimensional fast Fourier transform processing, a flattening process including primary inclination correction is preferably performed on the concavity and convexity analysis image.

Moreover, an average pitch of the concavities and convexities formed on the surface of the cured resin layer 12 is preferably within a range from 100 to 2000 nm, and more preferably within a range from 100 to 1100 nm. If the average pitch of the concavities and convexities is less than the lower limit, the pitch is so small relative to wavelengths of sunlight that necessary diffraction tends not to occur, so that the light confinement effect tends to be lowered in the use for a solar cell. Meanwhile, if the average pitch exceeds the upper limit, diffraction of light with wavelengths exceeding the band gap of a semiconductor used in a solar cell mainly occurs, and no contribution is made to the photoelectric conversion efficiency, but rather the efficiency tends to be lowered because of conversion to heat. Note that the average pitch of the concavities and convexities refers to an average value of pitches of the concavities and convexities obtained when the pitches of the concavities and convexities on the surface of the cured resin layer 12 (distances between adjacent convex portions or between adjacent concave portions) are measured. In addition, a value which can be calculated as follows is employed as the average value of pitches of the concavities and convexities. Specifically, a concavity and convexity analysis image of the shape of the concavities and convexities on the surface is obtained by use of a scanning probe microscope (for example, one manufactured by SII NanoTechnology Inc. , under the product name of "E-sweep", or the like), the distances between randomly selected adjacent convex portions or between randomly selected adjacent concave portions are measured at 10 points or more in the concavity and convexity analysis image, and then an average of these distances is determined. Moreover, such pitches of the concavities and convexities can be efficiently formed by use of a master block according to the present invention to be described later.

Moreover, in the present invention, the average pitch of the concavities and convexities formed on the surface of the cured resin layer 12 is preferably designed to be not longer than such a length that the ratio of the length to the wavelength corresponding to the band gap of the material for forming the semiconductor layer used for forming a solar cell is represented by the formula: $1/(ni-no)$, where (no) is the refractive index of the semiconductor layer, and (ni) is a refractive index of the substrate. If the average pitch of the concavities and convexities exceeds the upper limit, diffraction of light with wavelengths exceeding the band gap of the semiconductor mainly occurs, and no photoelectric conversion occurs. Instead, only conversion to heat occurs, so that the photoelectric conversion efficiency tends to be lowered. Note that the lower limit of the average pitch of the concavities and convexities is preferably 100 nm or more, because a too-small pitch relative to wavelengths of sunlight results in an insufficient diffraction effect as described above.

In addition, an average height of the concavities and convexities formed on the surface of the cured resin layer 12 is preferably within a range from 5 to 200 nm, more preferably within a range from 20 to 200 nm, and further preferably within a range from 50 to 150 nm. If the average height (depth) of the concavities and convexities is less than the lower limit, the height is so small relative to wavelengths of visible light that necessary diffraction tends not to occur, resulting in a tendency that a light confinement effect is lowered in the use for a solar cell. Meanwhile, if the height exceeds the upper limit, a coatability rend to be lowered, and the photoelectric conversion efficiency tends to be lowered, depending on a film stacked on the concave and convex substrate or the kind of the film. Note that the average height of the concavities and convexities refers to an average value of heights of the concavities and convexities obtained when the heights of the concavities and convexities (distances between concave portions and convex portions in the depth direction) on the surface of the cured resin layer are measured. In addition, a value calculated as follows is employed as the average value of heights of the concavities and convexities. Specifically, a concavity and convexity analysis image of the shape of the concavities and convexities on the surface is obtained by use of a scanning probe microscope (for example, one manufactured by SII NanoTechnology Inc. , under the product name of "E-sweep", or the like), then the distances between randomly selected concave portions and convex portions in the depth direction are measured at 10 points or more in the concavity and convexity analysis image, and then an average of these distances is determined. Note that such a height (depth) of the concavities and convexities can easily be achieved by use of a master block according to the present invention to be described later.

The transparent electroconductive layer 13 is a transparent layer having electrical conductivity, and is a layer usable as a transparent electrode in a solar cell. The transparent electroconductive layer 13 is not particularly limited, as long as the layer is made of a material which can be used as a transparent electrode of a solar cell. For example, a thin film of a metal such as gold, silver, chromium, copper, or tungsten, or a conductive film made of a metal oxide can be used as the transparent electroconductive layer 13. As the metal oxide, metal oxides of tin, zinc, or the like doped with a trace amount of another metal element (for example, indium tin oxide (ITO ($In_2O_3$:Sn)), fluorine-doped tin oxide (FTO ($SnO_2$:F)), aluminum-doped zinc oxide (AZO (ZnO:Al)), indium-doped zinc oxide (IZO (ZnO:I)), germanium-doped zinc oxide (GZO(ZnO:Ge)), and the like) are preferably used.

A thickness of the transparent electroconductive layer 13 is preferably 10 to 2000 nm, and more preferably 100 nm to 1000 nm. If the thickness of the transparent electroconductive layer 13 is less than the lower limit, a sufficient resistance value cannot be obtained, so that the photoelectric conversion efficiency tends to decrease. Meanwhile, a thickness exceeding the upper limit tends to be disadvantageous in terms of drop in transmittance, and of production efficiency because the film formation time is increased.

In addition, a surface resistance (sheet resistance) of the transparent electroconductive layer 13 is preferably 50 $\Omega$/sq or less, and more preferably 10 $\Omega$/sq or less. If the resistance value of the transparent electroconductive layer 13 exceeds the upper limit, a photoelectric conversion efficiency tends to be lowered, because a propagation efficiency of carriers generated by the photoelectric effect is lowered.

Hereinabove, the preferred embodiment of the transparent electroconductive substrate for a solar cell of the present invention is described. However, the transparent electroconductive substrate for a solar cell of the present invention is not limited to the above-described embodiment. For example, in the embodiment shown in Fig. 1, the transparent electroconductive substrate comprises: the transparent supporting substrate 11; the cured resin layer 12 which is stacked on the transparent supporting substrate 11 and which has concavities and convexities formed on a surface thereof; and the transparent electroconductive layer 13 stacked on the cured resin layer 12. In the present invention, however, the transparent electroconductive substrate only needs to comprise: a transparent supporting substrate; a transparent electroconductive layer; and a cured resin layer placed between the transparent supporting substrate and the transparent electroconductive layer. The transparent electroconductive substrate may further comprise other layers (including an adhesive layer and the like) usable in a solar cell between these layers, as long as effects of the invention are not impaired.

Next, description is given of a method preferably usable for manufacturing the transparent electroconductive substrate for a solar cell of the present invention. As this method, the above-described method for manufacturing a transparent electroconductive substrate for a solar cell of the present invention can preferably be employed, for example.

The method for manufacturing a transparent electroconductive substrate for a solar cell of the present invention comprises the steps of:

applying a curable resin onto a transparent supporting substrate, then curing the curable resin with a master block being pressed thereto, and thereafter detaching the master block, thereby stacking, on the transparent supporting substrate, a cured resin layer having concavities and convexities formed thereon (first step); and

stacking, on the cured resin layer, a transparent electroconductive layer having such a shape that the shape of the concavities and convexities formed on a surface of the cured resin layer is maintained, thereby obtaining a transparent electroconductive substrate for a solar cell, the transparent electroconductive substrate comprising the transparent supporting substrate, the cured resin layer, and the transparent electroconductive layer (second step), wherein the master block is obtained by a method comprising the steps of:

applying a block copolymer solution comprising a block copolymer and a solvent onto a base member, the block copolymer having a first polymer segment made of a first homopolymer and a second polymer segment made of a second homopolymer having a solubility parameter which is higher than a solubility parameter of the first homopolymer by 0.1 to 10 $(cal/cm^3)^{1/2}$, and satisfying all the following requirements (i) to (iii):

(i) a number average molecular weight is 500000 or more,
(ii) a molecular weight distribution (Mw/Mn) is 1.5 or less, and
(iii) a volume ratio between the first polymer segment and the second polymer segment (the first polymer segment:the second polymer segment) is 3:7 to 7:3 (block copolymer solution application step); and

forming a micro phase separation structure of the block copolymer by drying a coating film on the base member, thereby obtaining a first master block having concavities and convexities formed on a surface thereof (first master block formation step).

Hereinafter, the first step and the second step are described separately.

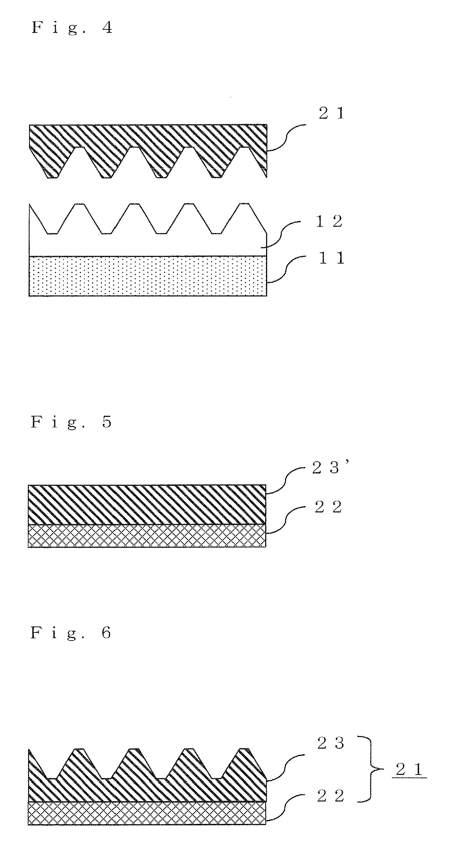

First, the first step is described. Figs. 2 to 4 are vertical cross-sectional views schematically showing a state where a resin is applied onto a substrate and the like for describing a preferred embodiment of the first step. Specifically, Fig. 2 is a vertical cross-sectional view schematically showing a state where a curable resin is applied onto a transparent supporting substrate; Fig. 3 is a vertical cross-sectional view schematically showing a state where the curable resin is cured with a master block being pressed thereto; and Fig. 4 is a vertical cross-sectional view schematically showing a state where concavities and convexities are formed on a surface of a cured resin layer by detaching the master block.

In the first step, a curable resin 12' is first applied onto a transparent supporting substrate 11, as shown in Fig. 2, and then the curable resin 12' is cured with a master block 21 being pressed thereto, as shown in Fig. 3. The transparent supporting substrate 11 is preferably such that a thickness of the transparent supporting substrate 11 is within a range from 1 to 500 $\mu$m.

In addition, examples of the curable resin 12' include epoxy resins, acrylic resins, urethane resins, melamine resins, urea resins, polyester resins, phenol resins, cross-linking-type liquid crystal resins, and silicone resins (resins having main skeletons of siloxane bonds). In addition, the thickness of the curable resin 12' applied is preferably within a range which allows the thickness of the resulting cured resin layer 12 to be 0.1 to 5000 $\mu$m. If the thickness of the curable resin 12' applied is less than the lower limit, the height of the concavities and convexities formed on the surface of the cured resin layer tends to be insufficient. Meanwhile, if the thickness exceeds the upper limit, an effect of volume change of the resin which occurs upon curing tends to be so large that the formation of the shape of the concavities and convexi ties tends to be poor. Moreover, such an applied thickness enables the thickness of the cured resin layer 12 to be 0.5 to 500 $\mu$m.

In addition, examples of methods employable as a method for applying the curable resin 12' include various coating methods such as a spin coating method, a spray coating method, a dip coating method, a dropping method, a gravure printing method, a screen printing method, a relief printing method, a die coating method, a curtain coating method, an inkjet method, and a sputtering method. Moreover, the conditions for curing the curable resin 12' vary depending on the kind of the resin used, the conditions are preferably such that the curing temperature is within a range from room temperature to 250°C, and the curing time is within a range from 0.5 minutes to 3 hours, for example. In addition, as a method for curing the curable resin 12', a method may be employed in which the curable resin 12' is cured by irradiation with energy rays such as ultraviolet rays or electron beams. In such a case, the amount of the irradiation is not particularly limited, and is preferably within a range from 20 mJ/cm$^2$ to 10 J/cm$^2$, and more preferably within a range from 20 mJ/cm$^2$ to 5 J/cm$^2$.

In the first step, subsequently, the master block 21 is detached from a cured resin layer 12, as shown in Fig. 4. A method for detaching the master block 21 from the cured resin layer 12 is not particularly limited, and a known method can be employed as appropriate. Thus, the cured resin layer 12 having concavities and convexities formed thereon can be stacked on the transparent supporting substrate 11 (see Fig. 4).

In addition, the master block 21 used in the first step is obtained by a method comprising the block copolymer solution application step and the first master block formation step described above.

Figs. 5 and 6 are schematic diagrams (vertical cross-sectional views) for describing a preferred embodiment of a method for manufacturing a master block used in the method for manufacturing a transparent electroconductive substrate for a solar cell of the present invention. Here, Fig. 5 is a vertical cross-sectional view schematically showing a state where a block copolymer solution is applied onto a base member in manufacturing a master block, and Fig. 6 is a vertical cross-sectional view schematically showing a state where concavities and convexities are formed on a surface of a coating film by forming a micro phase separation structure of a block copolymer in manufacturing the master block.

In the block copolymer solution application step, the block copolymer solution is applied onto a base member 22, as shown in Fig. 5.

The base member 22 is not particularly limited, and examples thereof include substrates of resins such as polyimide, polyphenylene sulfide, polyphenylene oxide, polyether ketone, polyethylene naphthalate, polyethylene terephthalate, polyarylate, triacetyl cellulose, and polycycloolefin; inorganic substrates such as glass and silicon substrates; and substrates of metals such as aluminum, iron, and copper. In addition, the base member 22 may be subjected to surface treatments such as an orientation treatment.

The block copolymer used in the present invention has a first polymer segment made of a first homopolymer and a second polymer segment made of a second homopolymer having a solubility parameter which is higher than a solubility parameter of the first homopolymer by 0.1 to 10 $(cal/cm^3)^{1/2}$. If the difference between the solubility parameters of the first and second homopolymers is less than $0.1(cal/cm^3)^{1/2}$, a regular micro phase separation structure of the block copolymer cannot be formed. Meanwhile, if the difference exceeds 10 $(cal/cm^3)^{1/2}$, a uniform solution of the block copolymer is difficult to prepare, so that a regular micro phase separation structure of the block copolymer is difficult to form.

Examples of monomers serving as raw materials of homopolymers usable as the first homopolymer or the second homopolymer include styrene, methylstyrene, propylstyrene, butylstyrene, hexylstyrene, octylstyrene, methoxystyrene, ethylene, propylene, butene, hexene, acrylonitrile, acrylamide, methyl methacrylate, ethyl methacrylate, propyl methacrylate, butyl methacrylate, hexyl methacrylate, octyl methacrylate, methyl acrylate, ethyl acrylate, propyl acrylate, butyl acrylate, hexyl acrylate, octyl acrylate, methacrylic acid, acrylic acid, hydroxyethyl methacrylate, hydroxyethyl acrylate, ethylene oxide, propylene oxide, dimethylsiloxane, lactic acid, vinylpyridine, hydroxystyrene, styrenesulfonate, isoprene, butadiene, ε-caprolactone, isopropylacrylamide, vinyl chloride, ethylene terephthalate, tetrafluoroethylene, and vinyl alcohol. Of these monomers, styrene, methyl methacrylate, ethylene oxide, butadiene, isoprene, vinylpyridine, and lactic acid are preferably used from the viewpoints that the formation of separated phases easily occurs, and that the concavities and convexities are easily formed by etching.

In addition, examples of the combination of the first homopolymer and the second homopolymer include combinations of two selected from the group consisting of a styrene-based polymer (more preferably polystyrene), a polyalkyl methacrylate (more preferably polymethyl methacrylate), polyethylene oxide, polybutadiene, polyisoprene, polyvinylpyridine, and polylactic acid. Of these combinations, combinations of a styrene-based polymer and a polyalkyl methacrylate, combinations of a styrene-based polymer and polyethylene oxide, combinations of a styrene-based polymer and polyisoprene, combinations of a styrene-based polymer and polybutadiene are more preferable, and combinations of a styrene-based polymer and polymethyl methacrylate, combinations of a styrene-based polymer and polyisoprene, and combinations of a styrene-based polymer and polybutadiene are particularly preferable, from the viewpoint that the depths of the concavities and convexities formed on the block copolymer can be further increased by preferentially removing one of the homopolymers by an etching treatment.

The number average molecular weight (Mn) of the block copolymer needs to be 500000 or more, and is more preferably 1000000 or more, and particularly preferably 1000000 to 5000000. If the number average molecular weight is less than 500000, the average pitch of the concavities and convexities formed by the micro phase separation structure of the block copolymer is so small that the average pitch of the concavities and convexities of the obtained cured resin layer becomes insufficient.

The molecular weight distribution (Mw/Mn) of the block copolymer needs to be 1.5 or less, and is more preferably 1.0 to 1.35. If the molecular weight distribution exceeds 1.5, a regular micro phase separation structure of the block copolymer cannot be formed.

Note that the number average molecular weight (Mn) and the weight average molecular weight (Mw) of the block copolymer are values measured by gel permeation chromatography (GPC) and converted to molecular weights of standard polystyrene.

In the block copolymer, a volume ratio between the first polymer segment and the second polymer segment (the first polymer segment:the second polymer segment) needs to be 3:7 to 7:3, and is more preferably 4:6 to 6:4. If the volume ratio is out of the above-described range, a concavity and convexity pattern owing to a lamellar structure is difficult to form.

The block copolymer solution used in the present invention comprises the block copolymer and a solvent. Examples of the solvent include aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycol ethers such as ethylene glycol dimethyl ether, diethylene glycol dimethyl ether, triglyme, propylene glycol monomethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; and mixture solvents thereof. A percentage content of the block copolymer in the block copolymer solution is preferably 0.1 to 15% by mass, and more preferably 0. 3 to 5% by mass, relative to 100% by mass of the block copolymer solution.

In addition, the block copolymer solution may further comprise a different homopolymer (a homopolymer other than the first homopolymer and the second homopolymer in the block copolymer contained in the solution: for example, when the combination of the first homopolymer and the second homopolymer in the block copolymer is a combination of polystyrene and polymethyl methacrylate, the different homopolymer may be any kind of homopolymer other than polystyrene and polymethyl methacrylate), a surfactant, an ionic compound, an anti-foaming agent, a leveling agent, and the like. When the block copolymer solution further comprises the different homopolymer, the concavities and convexities formed by micro phase separation of the block copolymer tend to be deeper.

In addition, a polyalkylene oxide is preferably used as the different homopolymer, because the effect (an effect of making the concavities and convexities deeper) is further advanced. Moreover, as the polyalkylene oxide, polyethylene oxide or polypropylene oxide is more preferable, and polyethylene oxide is particularly preferable. In addition, as the polyethylene oxide, one represented by the following formula is preferable:

$$HO-(CH_2-CH_2-O)_n-H$$

[in the formula, n represents an integer of 10 to 5000 (more preferably an integer of 50 to 1000, and further preferably an integer of 50 to 500)]. If the value of n is less than the lower limit, the molecular weight is so low that the effect tends to disappear because the polyethylene oxide is lost due to volatilization, vaporization, or the like during a heat treatment at a high temperature. Meanwhile, if the value exceeds the upper limit, the molecular weight it so high that the molecular mobility is low. Hence, the speed of the phase separation is lowered so that the formation of the micro phase separation structure tends to be insufficient.

In addition, the number average molecular weight (Mn) of the different homopolymer is preferably 460 to 220000, and is more preferably 2200 to 46000. If the number average molecular weight is less than the lower limit, the molecular weight is so low that the effect tends to disappear because the different homopolymer is lost due to volatilization, vaporization, or the like during a heat treatment at a high temperature. Meanwhile, if number average molecular weight (Mn) exceeds the upper limit, the molecular weight is so high that the molecular mobility is low. Hence, the speed of the phase separation is lowered so that the formation of the separated micro phases tends to be insufficient.

The molecular weight distribution (Mw/Mn) of the different homopolymer is preferably 1.5 or less, and more preferably 1.0 to 1.3. If the molecular weight distribution exceeds the upper limit, the uniformity of the shape of the micro phase separation tends not to be maintained. Note that the number average molecular weight (Mn) and the weight average molecular weight (Mw) are values measured by gel permeation chromatography (GPC) and converted to molecular weights of standard polystyrene.

In addition, when the different homopolymer is used in the present invention, it is preferable that the combination of the first homopolymer and the second homopolymer in the block copolymer be a combination of polystyrene and polymethyl methacrylate (polystyrene-polymethyl methacrylate), and the different homopolymer be a polyalkylene oxide. The use of a polystyrene-polymethyl methacrylate block copolymer and a polyalkylene oxide in combination as described above leads to tendencies that the orientation in the vertical direction is further improved, making it possible to further increase the depths of the concavities and convexities on the surface, and that the heat treatment time during manufacturing can be shortened.

When the different homopolymer is used, the content thereof is preferably 100 parts by mass or less, and more preferably 5 parts by mass to 100 parts by mass, relative to 100 parts by mass of the block copolymer. If the content of the different homopolymer is less than the lower limit, the effect obtained by the different homopolymer contained tends to be insufficient.

In addition, when the surfactant is used, the content thereof is preferably 10 parts by mass or less relative to 100 parts by mass of the block copolymer. Moreover, when the ionic compound is used, the content thereof is preferably 10 parts by mass or less relative to 100 parts by mass of the block copolymer.

In addition, when the block copolymer solution comprises the different homopolymer, the total percentage content of the block copolymer and the different homopolymer is preferably 0.1 to 15% by mass, and more preferably 0.3 to 5% by mass, in the block copolymer solution. If the total percentage content is less than the lower limit, it tends to be impossible to uniformly apply the solution to a wet film thickness sufficient to obtain a necessary film thickness. Meanwhile, if the total percentage content exceeds the upper limit, it tends to be difficult to prepare a solution in which those are uniformly dissolved in the solvent.

The method for applying the block copolymer solution is not particularly limited, and, for example, a spin coating method, a spray coating method, a dip coating method, a dropping method, a gravure printing method, a screen printing method, a relief printing method, a die coating method, a curtain coating method, or an inkjet method can be employed as the method.

The thickness of a coating film 23' of the block copolymer is preferably within a range which allows the thickness of the dried coating film 23 to be 10 to 3000 nm, and more preferably within a range which allows the thickness of the dried coating film 23 to be 50 to 500 nm. In addition, the thickness of the dried coating film 23 is preferably close to an integral multiple of a lamellar period of the block copolymer.

In the first master block formation step, concavities and convexities are formed on the surface of the dried coating film 23 by drying the coating film 23' on the base member 22, thereby forming a micro phase separation structure of the block copolymer as shown in FIG. 6. The temperature for drying the coating film 23' is not particularly limited, as long as the solvent can be removed from the coating film 23'. For example, the temperature is preferably 30 to 200°C, and more preferably 40 to 100°C. Thus, a first master block 21 comprising the base member 22 and the dried coating film 23 and having the concavities and convexities formed on the surface thereof can be obtained.

In the step of obtaining the first master block, the dried coating film 23 is preferably heated at a temperature higher than the glass transition temperature (Tg) of the block copolymer. If the heating temperature is lower than the lower limit, the molecular mobility is so low that the time required for the formation of the micro phase separation structure tends to be long. In addition, the upper limit of the heating temperature is not particularly limited, unless the block copolymer is pyrolyzed at the temperature.

Note that, to further improve the regularity of the concavities and convexities formed by the micro phase separation structure, the dried coating film 23 may be subjected appropriately to, for example, any of a step of improving the regularity of the concavities and convexities, in which a treatment with an organic solvent is conducted on the dried coating film 23 by allowing the dried coating film 23 to stand still at a saturated vapor pressure of a specific organic solvent (for example, chloroform) for about 3 to 240 hours; a step of improving the regularity of the concavities and convexities by utilizing an electric field; a step of improving the regularity of the concavities and convexities by utilizing a shearing force; a step of improving the regularity of the concavities and convexities by utilizing a supercritical fluid; and the like, instead of the above-described step of heating the dried coating film 23 at a temperature higher than the glass transition temperature (Tg) thereof. Note that, of these steps, a preferred step may be selected as appropriate depending on the kind of the block copolymer, the kind of the solvent, the kind of the different homopolymer, and the like. For example, when a polystyrene-polymethyl methacrylate block copolymer and a polyalkylene oxide (the different polymer) are used in combination for the block copolymer solution, it is particularly preferable to employ the step of heating the dried coating film 23 at a temperature higher than the glass transition temperature (Tg) of the block copolymer.

In the step of obtaining a first master block, the dried coating film 23 is preferably subjected to an etching treatment. As a result of the etching treatment, the concavities and convexities formed by the micro phase separation of the block copolymer tend to be deeper. For example, an etching method using a reactive ion etching method, an ozone oxidation method, a hydrolysis method, a metal ion staining method, an ultraviolet-ray etching method, or the like can be employed as the etching treatment. Moreover, as the etching treatment, a method may be employed in which covalent bonds in the block copolymer are cleaved by treating the covalent bonds with at least one selected from the group consisting of acids, bases, and reducing agents, and then the coating film in which the micro phase separation structure is formed is washed with a solvent which dissolves only one of the polymer segments, or the like, thereby removing only the one of the polymer segments, while keeping the micro phase separation structure.

As described above, the first master block has concavities and convexities due to micro phase separation structure formed on the surface thereof. The first master block is such that a Fourier-transformed image obtained when a concavity and convexity analysis image is obtained by analyzing the shape of the concavities and convexities formed on the surface by use of an atomic force microscope, and then two-dimensional fast Fourier transform processing is performed on the concavity and convexity analysis image shows a circular or annular pattern. Specifically, the Fourier-transformed image shows a circular or annular pattern substantially centered at an origin at which an absolute value of wavenumber is 0 $\mu m^{-1}$, and the circular or annular pattern is present within a region where an absolute value of wavenumber is within a range from 0.5 to 10 $\mu m^{-1}$ (more preferably 0.9 to 10 $\mu m^{-1}$). The use of the first master block 21 having concavities and convexities formed thereon as a master block makes it possible to form a shape of concavities and convexities having characteristics originated from the characteristics of the concavities and convexities of the master block on the cured resin layer formed, and thus makes it possible to efficiently form the cured resin layer 12.

The average pitch of the concavities and convexities formed on the surface of the first master block is preferably within a range from 100 to 2000 nm, and more preferably within a range from 100 to 1100 nm. If the average pitch of the concavities and convexities is less than the lower limit, the pitch is so small relative to wavelengths of the visible light that necessary diffraction tends not to occur in the cured resin layer obtained by use of such a master block. Meanwhile, if the average pitch exceeds the upper limit, the diffraction angle of the cured resin layer obtained by use of such a master block is so small that the light diffraction function of the cured resin layer tends to be lost. Note that the average pitch of the concavities and convexities refers to an average value of pitches of the concavities and convexities obtained when the pitches of the concavities and convexities on the surface of the cured resin layer (distances between adjacent convex portions or between adjacent concave portions) are measured. In addition, a value calculated as follows is employed as the average value of pitches of the concavities and convexities. Specifically, a concavity and convexity analysis image is obtained by measuring the shape of the concavities and convexities on the surface by use of a scanning probe microscope (for example, one manufactured by SII NanoTechnology Inc., under the product name of "E-sweep", or the like), then the distances between randomly selected adjacent convex portions or between randomly selected adjacent concave portions are measured at 10 points or more in the concavity and convexity analysis image, and then an average of these distances is determined.

In addition, the average height of the concavities and convexities formed on the surface of the first master block is preferably within a range from 5 to 200 nm, more preferably within a range from 20 to 200 nm, and further preferably within a range from 50 to 150 nm. If the average height of the concavities and convexities is less than the lower limit, the height is so small relative to the wavelengths of the visible light that necessary diffraction tends not to occur, when the obtained cured resin layer (diffraction grating) is used. Meanwhile, if the average height exceeds the upper limit, coatability tends to be lowered, and the photoelectric conversion efficiency tends to be lowered, depending on a film stacked on the concave and convex substrate or the kind of the film, when the obtained cured resin layer (diffraction grating) is used. Note that the average height of the concavities and convexities refers to an average value of heights of the concavities and convexities obtained when the heights of the concavities and convexities on the surface of the cured resin layer (distances between concave portions and convex portions in the depth direction) are measured. In addition, a value calculated as follows is employed as the average value of heights of the concavities and convexities. Specifically, a concavity and convexity analysis image is obtained by measuring the shape of the concavities and convexities on the surface by use of a scanning probe microscope (for example, one manufactured by SII NanoTechnology Inc., under the product name of "E-sweep", or the like), then distances between randomly selected concave portions and convex portions in the depth direction are measured at 10 points or more in the concavity and convexity analysis image, and the average of these distances is determined.

It is preferable to further comprise a step (second master block formation step) of attaching a transfer material 24' onto a first master block 21, then curing the transfer material 24', and thereafter detaching the transfer material from the first master block, thereby obtaining a second master block having concavities and convexities formed on a surface thereof.

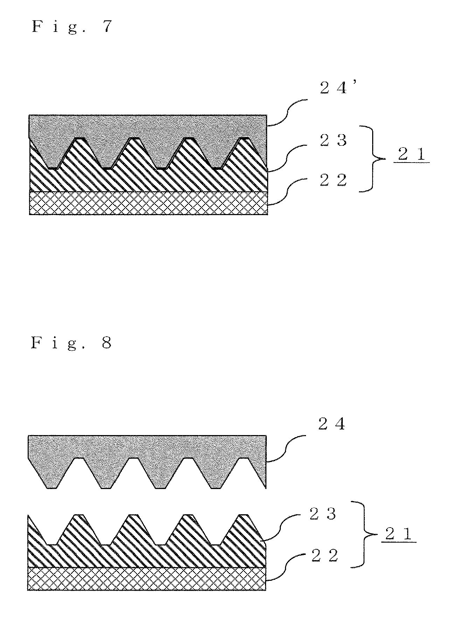

Fig. 7 is a vertical cross-sectional view schematically showing a state where a transfer material is attached onto a first master block in the method for manufacturing a master block according to the present invention, and Fig. 8 is a vertical cross-sectional view schematically showing a state where the cured second master block is detached from the first master block.

In the second master block formation step, first, the transfer material 24' is attached onto the first master block 21 and cured, as shown in Fig. 7. The transfer material 24' is not particularly limited, and examples thereof include inorganic substances such as nickel, silicon, silicon carbide, tantalum, glassy carbon, silica glass, and silica; and resin compositions such as silicone-based polymers (silicone rubbers), urethane rubbers, norbornene resins, polycarbonate, polyethylene terephthalate, polystyrene, polymethyl methacrylate, acrylic resins, liquid crystal polymers, and epoxy resins. Of these transfer materials, silicone-based polymers, nickel, silicon, silicon carbide, tantalum, glassy carbon, silica glass, silica, and acrylic resins are more preferable, silicone-based polymers and acrylic resins are further more preferable, and silicone-based polymers containing polydimethylsiloxane and fluorine-containing acrylic resins are particularly preferable, from the viewpoints of formability, followability to a fine pattern, and mold releasability. In addition, to enhance the mold releasability of the transfer material, a metal such as Pt, Al, Au, or Ni may be vapor deposited in a small thickness onto the master block 21. Alternatively, a treatment with a fluorine-containing mold release agent or other surface treatments may be conducted thinly. In addition, a method for attaching the transfer material 24' as described above is not particularly limited, and examples of employable methods include a vacuum vapor deposition method; and various coating methods such as a spin coating method, a spray coating method, a dip coating method, a dropping method, a gravure printing method, a screen printing method, a relief printing method, a die coating method, a curtain coating method, an inkj et method, and a sputtering method. In addition, although the conditions for curing the transfer material 24' vary depending on the kind of the transfer material used, the conditions are preferably such that the curing temperature is within a range from room temperature to 250°C, and the curing time is within a range from 0.5 minutes to 3 hours, for example. In addition, a method may be employed in which the transfer material 24' is cured by irradiation with energy rays such as ultraviolet rays or electron beams. In such a case, the amount of the irradiation is preferably within a range from 20 mJ/cm$^2$ to 10 J/cm$^2$.

In the second master block formation step, subsequently, a second master block 24 is obtained by detaching the cured transfer material 24 form the first master block 21, as shown in Fig. 8. A method for detaching the second master block 24 from the first master block 21 is not particularly limited, and a known method can be employed as appropriate. In addition, the second master block 24 may be manufactured directly from the first master block 21, as described above, or the second master block 24 may be manufactured from the first master block 21 through one or more intermediate master blocks. The intermediate master blocks can be formed by the same step as the second master block formation step, and, for example, the second master block 24 may be manufactured through an intermediate master block to invert the concavity and convexity structure. As a transfer material for manufacturing the intermediate master block, the same transfer materials as those used for the transfer material 24' can be used.

Hereinabove, the first step is described. Next, the second step is described. The second step is a step of stacking, on the cured resin layer, a transparent electroconductive layer having such a shape that the shape of the concavities and convexities formed on a surface of the cured resin layer is maintained, thereby obtaining a transparent electroconductive substrate for a solar cell, the transparent electroconductive substrate comprising the transparent supporting substrate, the cured resin layer, and the transparent electroconductive layer.

The step of manufacturing the transparent electroconductive layer 13 is not particularly limited, except that the transparent electroconductive layer having such a shape that the shape of the concavities and convexities formed on the surface of the cured resin layer is maintained is stacked. A known method capable of forming a transparent electroconductive layer for a solar cell can be used as appropriate, while employing temperature conditions and the like under which the shape of the concavities and convexities formed on the surface of the cured resin layer is maintained. As the method for manufacturing the transparent electroconductivelayer 13, a method can be employed in which a transparent electroconductive layer is manufactured on a substrate by using the above-described material for forming the transparent electroconductive layer 13 as appropriate, and employing a known method such as a vacuum vapor deposition method, an ion plating method, a CVD method, an electron beam vacuum vapor deposition method, or a sputtering method.

Hereinabove, the method for manufacturing a transparent electroconductive substrate for a solar cell of the present invention is descried. However, the method which can be preferably used for manufacturing a transparent electroconductive substrate for a solar cell of the present invention is not limited to the above-described method for manufacturing a transparent electroconductive substrate for a solar cell of the present invention. For example, a method may be employed in which a transparent electroconductive substrate for a solar cell is obtained by employing the same method as the above-described method for manufacturing a transparent electroconductive substrate for a solar cell of the present invention, except that a master block obtained by a method is used as the master block, the method comprising the steps of:

forming a vapor-deposition film under a temperature condition of 70°C or above on a surface of a polymer film made of a polymer whose volume changes by heat, and then cooling the polymer film and the vapor-deposition film, thereby forming concavities and convexities of wrinkles on a surface of the vapor-deposition film (a concave- and convex-shape formation step); and

attaching a master block material onto the vapor-deposition film, then curing the master block material, and thereafter detaching the cured master block material from the vapor-deposition film, thereby obtaining a master block (a master block formation step). Hereinafter, the concave- and convex-shape formation step and the master block formation step are described.

In the concave- and convex-shape formation step, first, a polymer film made of a polymer whose volume changes by heat is prepared. As the polymer whose volume changes by heat, one whose volume changes by heating or cooling (for example, one having a coefficient of thermal expansion of 50 ppm/K or more) can be used as appropriate. As the polymer, a silicone-based polymer is more preferable, and a silicone-based polymer containing polydimethylsiloxane is particularly preferable, from the viewpoint that the concavities and convexities of wrinkles are easily formed on the surface of the vapor-deposition film, because the difference between the coefficient of thermal expansion of the polymer and the coefficient of thermal expansion of the vapor-deposition film is large, and because the polymer has a high flexibility. As a method for forming the polymer film as described above, for example, a spin coating method, a dip coating method, a dropping method, a gravure printing method, a screen printing method, a relief printing method, a die coating method, a curtain coating method, an inkjet method, a spray coating method, a sputtering method, a vacuum vapor deposition method, or the like can be employed. Moreover, the thickness of the polymer film is preferably within a range from 10 to 5000 $\mu$m, and is more preferably within a range from 10 to 2000 $\mu$m.

In the concave- and convex-shape formation step, next, a vapor-deposition film is formed on a surface of the polymer film under a temperature condition of 70°C or above. The temperature at which the vapor-deposition film is formed needs to be 70°C or above, and is more preferably 90°C or above. If the temperature is lower than 70°C, the concavities and convexities of wrinkles cannot be formed sufficiently on the surface of the vapor-deposition film. As the method for forming the vapor-deposition film, a known method such as a vapor deposition method or a sputtering method can be employed as appropriate. Of these methods, a vapor deposition method is preferably employed, from the viewpoint of maintaining the shape of the concavities and convexities formed on the surface of the polymer film. Meanwhile, a material of the vapor-deposition film is not particularly limited, and examples thereof include metals such as aluminum, gold, silver, platinum, and nickel; and metal oxides such as aluminum oxide.

In the concave- and convex-shape formation step, subsequently, concavities and convexities of wrinkles are formed on the surface of the vapor-deposition film by cooling the polymer film and the vapor-deposition film. Since there is a deference between the coefficient of thermal expansion of the polymer film and the coefficient of thermal expansion of the vapor-deposition film as described above, the concavities and convexities of wrinkles (the so-called bucking pattern, or the so-called Turing pattern) can be formed on the surface of the vapor-deposition film, when the volume of each of the polymer film and vapor-deposition film changes by heat. In addition, the temperatures of the polymer film and the vapor-deposition film after the cooling are preferably 40°C or below. If the temperatures of the polymer film and the vapor-deposition film after the cooling exceed the upper limit, it tends to be difficult to form the concavities and convexities of wrinkles on the surface of the vapor-deposition film. Moreover, the rate of temperature drop in cooling the polymer film and the vapor-deposition film is preferably within a range from 1 to 80°C/minute. If the rate of temperature drop is less than the lower limit, the concavities and convexities tend to be relaxed. Meanwhile, if the rate of temperature drop exceeds the upper limit, scars such as cracks tend to be easily formed on the surface of the polymer film or the vapor-deposition film.

In the master block formation step, first, a master block material is attached on the vapor-deposition film and cured. The master block material is not particularly limited, and examples thereof include inorganic substances such as nickel, silicon, silicon carbide, tantalum, glassy carbon, silica glass, and silica; and resin compositions such as silicone-based polymers (silicone rubbers), urethane rubbers, norbornene resins, polycarbonate, polyethylene terephthalate, polystyrene, polymethyl methacrylate, acrylic, liquid crystal polymers. Of these master block materials, silicone-based polymers, nickel, silicon, silicon carbide, tantalum, glassy carbon, silica glass, and silica are more preferable, silicone-based polymers are further more preferable, and silicone-based polymers containing polydimethylsiloxane are particularly preferable, from the viewpoints of formability, followability to a fine pattern, and mold releasability. In addition, a method for attaching the master block material as described above is not particularly limited, and examples of employable methods include a vacuum vapor deposition method; and various coating methods such as a spin coating method, a spray coating method, a dip coating method, a dropping method, a gravure printing method, a screen printing method, a relief printing method, a die coating method, a curtain coating method, an inkjet method, and a sputtering method. In addition, although conditions for curing the master block material vary depending on the kind of the master block material used, the conditions are preferably such that the curing temperature is within a range from room temperature to 250°C, and the curing time is within a range from 0.5 minutes to 3 hours, for example. In addition, a method may be employed in which the master block material is cured by irradiation with energy rays such as ultraviolet rays or electron beams. In such a case, the amount of the irradiation is preferably within a range from 20 mJ/cm$^2$ to 10 J/cm$^2$.

In the master block formation step, subsequently, a master block is obtained by detaching the cured master block material from the vapor-deposition film. A method for detaching the master block from the vapor-deposition film as described above is not particularly limited, and a known method can be employed as appropriate.

When a polymer whose volume changes by heat is used as the master block material in the method for manufacturing a master block, the concave- and convex-shape formation step and the master block formation step may be repeated by use of a master block obtained as a polymer film. This makes it possible to deepen the winkles formed on the surface of the master block, and to increase the average height of the concavities and convexities formed on the surface of the master block. In addition, the use of the method for manufacturing a master block comprising the concave- and convex-shape formation step and the master block formation step also makes it possible to form, on the surface of the master block, such a shape of concavities and convexities that, when a concavity and convexity analysis image is obtained by analyzing the shape of the concavities and convexities by use of an atomic force microscope, a Fourier-transformed image obtained by performing two-dimensional fast Fourier transform processing on the concavity and convexity analysis image shows a circular or annular pattern, and the circular or annular pattern is present within a region where an absolute value of wavenumber is within a range from 0.5 to 10 $\mu$m$^{-1}$ (more preferably 0.9 to 10 $\mu$m$^{-1}$).

Next, a solar cell of the present invention is described. The solar cell of the present invention comprises:

a transparent electroconductive substrate;
a counter electrode electroconductive layer; and
a semiconductor layer placed between the transparent electroconductive substrate and the counter electrode electroconductive layer, wherein
the transparent electroconductive substrate comprises:

a transparent supporting substrate;
a transparent electroconductive layer; and
a cured resin layer placed between the transparent supporting substrate and the transparent electroconductive layer,
concavities and convexities are formed on a surface of the cured resin layer, the surface facing the transparent electroconductive layer, and
when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu$m$^{-1}$, and the circular or annular pattern is present within a region where an absolute value of wavenumber is within a range from 0.5

to 10 $\mu m^{-1}$. Specifically, the solar cell of the present invention comprises:

a transparent electroconductive substrate;

a counter electrode electroconductive layer; and

a semiconductor layer placed between the transparent electroconductive substrate and the counter electrode electroconductive layer, wherein

the transparent electroconductive substrate is the above-describe transparent electroconductive substrate for a solar cell of the present invention. In the solar cell of the present invention, the above-described transparent electroconductive substrate for a solar cell of the present invention is used as the transparent electroconductive substrate. Hence, a sufficiently high light confinement effect can be obtained by allowing efficient incidence of light irrespective of the position of the sun. Accordingly, a sufficiently high level of photoelectric conversion efficiency can be achieved. Note that preferred transparent electroconductive substrates in the solar cell are the same as those described as preferred ones for the above-described transparent electroconductive substrate for a solar cell of the present invention.

In addition, in the transparent electroconductive substrate of the solar cell, the average pitch of the concavities and convexities formed on a surface of the cured resin layer, the surface facing the transparent electroconductive layer, is preferably designed to be not longer than such a length that the ratio of the length to the wavelength corresponding to the band gap of the material for forming the semiconductor layer used for forming a solar cell is represented by the formula: 1/(ni-no), where (no) is a refractive index of the semiconductor layer, and (ni) is an refractive index of the substrate. If the average pitch of the concavities and convexities exceeds the upper limit, diffraction of light with wavelengths exceeding the band gap of the semiconductor mainly occurs, and no photoelectric conversion occurs. Instead, only conversion to heat occurs, so that the photoelectric conversion efficiency tends to be lowered. On the other hand, the lower limit is preferably 100 nm or more, because a too-small pitch relative to wavelengths of sunlight results in an insufficient diffraction effect.

Moreover, the semiconductor layer in the solar cell of the present invention is not particularly limited, as long as the semiconductor layer is capable of photoelectric conversion. The semiconductor layer may be a layer made of a known semiconductor usable for manufacturing a solar cell. Examples of a material of the semiconductor include known materials such as silicon, germanium, silicon-germanium, silicon carbide, gallium arsenide (GaAs), indium antimonide (InSb), and cadmium selenide (CdSe). Moreover, the structure of the semiconductor layer is not particularly limited, and may be, for example, a structure in which a p-type semiconductor layer, an i-type semiconductor layer, and an n-type semiconductor layer are stacked in this order. The n-type semiconductor layer may be doped with a known donor element such as phosphorus (P) or arsenic (As), for example. Meanwhile, the p-type semiconductor layer may be doped with a known acceptor element such as boron (B) or aluminum (Al), for example. A method for forming the semiconductor layer is not particularly limited, and a known method can be employed as appropriate. For example, a CVD method, a sputtering method, a vapor deposition method, or the like may be employed. Note that, also in the step of forming the semiconductor layer, the semiconductor layer is preferably formed under a temperature condition as low as possible, and the semiconductor layer is preferably formed under a temperature condition of 200°C or below, from the viewpoint of sufficiently maintaining the concave and convex structure of the cured resin layer 12 in the transparent electroconductive substrate for a solar cell. For example, when silicon is used as the semiconductor layer, the following method can be employed as a step of forming the semiconductor layer. Specifically, in this method, silicon is deposited as appropriate by setting a substrate temperature to about 180°C, and using monosilane ($SiH_4$) as a raw material gas, while, if necessary, the above-described donor element, the above-described acceptor element, or the like is being added as appropriate to the raw material gas, so that a desired structure can be obtained. In addition, the thickness of the thus formed semiconductor layer is not particularly limited, and is preferably 100 to 5000 nm.

Moreover, in the solar cell of the present invention, both the transparent electroconductive layer in the transparent electroconductive substrate and the counter electrode electroconductive layer function as electrodes. The counter electrode electroconductive layer is not particularly limited, and may be a layer made of a known material usable for manufacturing an electrode of a solar cell. The material of the counter electrode electroconductive layer is not particularly limited, and gold, silver, chromium, copper, tungsten, the metal oxides described for the transparent electroconductive layer in the transparent electroconductive substrate for a solar cell, and the like can be used as appropriate, for example. In addition, the step of forming the counter electrode electroconductive layer is not particularly limited, and a known method can be employed as appropriate. For example, a CVD method, a sputtering method, a vapor deposition method (for example, an electron beam deposition method), or the like may be employed.

In addition, a structure of the solar cell only needs to comprise the transparent electroconductive substrate, the counter electrode electroconductive layer, and the semiconductor layer placed between the transparent electroconductive substrate and the counter electrode electroconductive layer, and the other aspects of the structure are not particularly limited. As long as the effects of the present invention are not impaired, other layers (known layers used for a solar cell: for example, a reflection layer, a back surface substrate, and the like) may be used as appropriate. Accordingly, the structure of the solar cell may be, for example, transparent electroconductive substrate for a solar cell/semiconductor layer/counter electrode electroconductive layer/reflection layer, or transparent electroconductive substrate for a solar cell/semiconductor layer/counter electrode electroconductive layer/reflection layer/back surface substrate (in the description, "/" means being stacked). Note that, as the reflection layer and the back surface substrate, known ones can be used as appropriate, and, as manufacturing methods thereof, known methods can be used as appropriate.

[Examples]

Hereinafter, the present invention will be described more specifically on the basis of Examples and Comparative Example. However, the present invention is not limited to Examples below.

<Kinds of Block Copolymer>

Resins such as a block copolymer used in Examples are described. Note that a volume ratio between the first and second polymer segments (first polymer segment:second polymer segment) in the block copolymer was calculated on the assumption that the density of polystyrene (PS) was 1.05 g/cm$^3$, and the density of polymethyl methacrylate (PMMA) was 1.19 g/cm$^3$. Moreover, the number average molecular weights (Mn) and the weight average molecular weights (Mw) of polymer segments and polymers were measured by gel permeation chromatography (Model No: "GPC-8020" manufactured by Tosoh Corporation, in which TSK-GEL SuperH1000, SuperH2000, SuperH3000, and SuperH4000 were connected in series). The glass transition temperatures (Tg) of polymer segments were measured by use of a differential scanning calorimeter (manufactured by Perkin-Elmer under the trade name of "DSC7"), while the temperature was raised at a rate of temperature rise of 20°C/min over a temperature range from 0 to 200°C. In addition, the solubility parameters of PS and PMMA are 9.0, 9.3, and 8.1, respectively (see Kagaku Binran Ouyou Hen (Handbook of Chemistry, Applied Chemistry) 2nd edition). Block Copolymer (P-1): a block copolymer of PS and PMMA manufactured by Polymer Source Inc, Mn of the PS segment=868, 000, Mn of the PMMA segment=857, 000, Mn of the block copolymer of PS and PMMA=1720000, the volume ratio between the PS segment and the PMMA segment (PS:PMMA)=53:47, the molecular weight distribution (Mw/Mn)=1.30, Tg of the PS segment=96°C, and Tg of PMMA segment=110°C. Homopolymer (A): polyethylene oxide (PEO) manufactured by Tokyo Chemical Industry Co., Ltd. under the trade name of "polyethylene glycol 4000", Mw of the homopolymer=3000, and the molecular weight distribution (Mw/Mn)=1.10.

<Measurement Methods for Concavity and Convexity Analysis Image and Fourier-Transformed Image>

Concavity and convexity analysis images of the shapes of the concavities and convexities of cured resin layers and master blocks of Examples were obtained by analysis using an atomic force microscope (a scanning probe microscope equipped with an environment control unit "Nanonavi II Station/E-sweep" manufactured by SII NanoTechnology Inc.) under the following analysis conditions:

Measurement mode: dynamic force mode
Cantilever: SI-DF40 (material: Si, lever width: 40 μm,
diameter of a tip of chip: 10 nm)
Measurement atmosphere: in air
Measurement temperature: 25°C

In addition, Fourier-transformed images of the shapes of the concavities and convexities were obtained by performing a flattening process including primary inclination correction on the concavity and convexity analysis images, and then performing two-dimensional fast Fourier transform processing thereon.

(Example 1)

<Step of Manufacturing Master Block (M-3)>

First, 99 mg of Block Copolymer (P-1) was dissolved in 10 g of toluene, and then the solution was filteredthrough a membrane filter having a pore diameter of 0.45 μm. Thus, a block copolymer solution was obtained. The obtained block copolymer solution was spin coated on a polyethylene naphthalate film (manufactured by Teijin DuPont Films Japan Limited) serving as a base member at a spin speed of 800 rpm. Then, the coating film was dried on a hot plate of 55°C for 10 minutes, and subsequently subjected to an annealing treatment in a vacuum oven of 130°C for 24 hours. Thus, First Master Block (M-1) having concavities and convexities formed on a surface thereof due to micro phase separation was obtained.

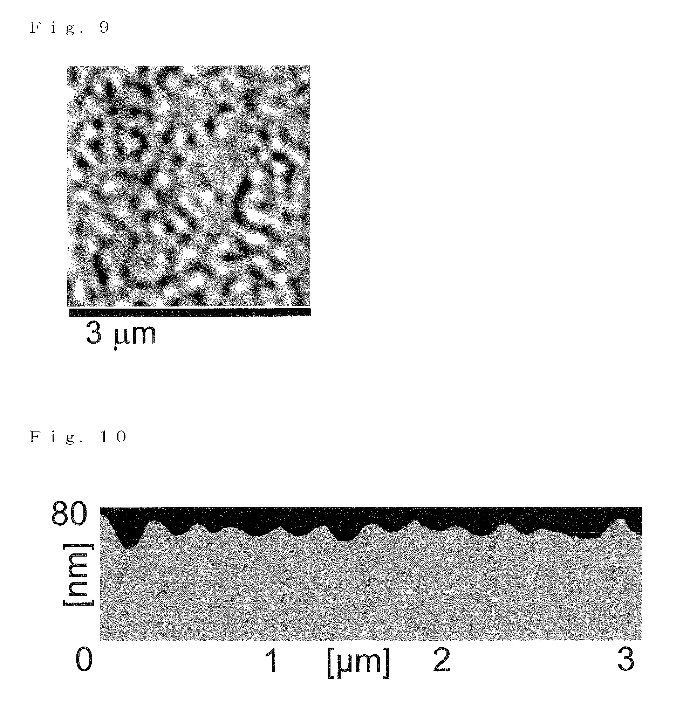

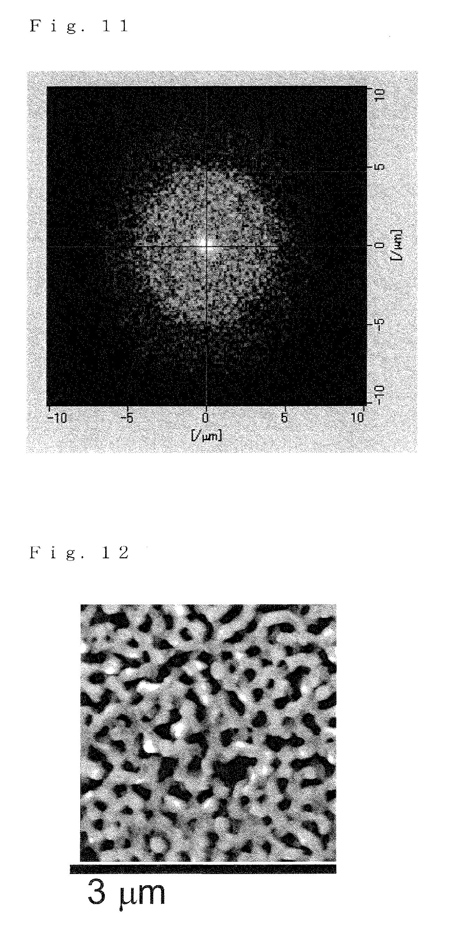

Concavity and convexity analysis images and a Fourier-transformed image of the thus obtained First Master Block (M-1) were obtained by employing the above-described measurement methods for a concavity and convexity analysis image and a Fourier-transformed image. Fig. 9 shows the obtained concavity and convexity analysis image, Fig. 10 shows the obtained cross-sectional concavity and convexity analysis image, and Fig. 11 shows the obtained Fourier-transformed image. As is apparent from the concavity and convexity analysis images shown in Figs. 9 and 10, it was found that concavities and convexities due to micro phase separation were formed on the surface of First Master Block (M-1). Moreover, as is apparent from the results shown in Fig. 11, it was found that the Fourier-transformed image showed a circular pattern substantially centered at an origin at which an absolute value of wavenumber was 0 $\mu m^{-1}$, and the circular pattern was such that 90% or more of bright spots constituting the Fourier-transformed image were present in a region where an absolute value of wavenumber was within a range from 0.5 to 5 $\mu m^{-1}$. In addition, the average pitch of the concavities and convexities of Master Block (M-1) was 280 nm, and the average height of the concavities and convexities thereof was 5 nm. Note that the average pitch and average height were calculated by determining heights and distances at randomly selected 10 points based on the concavity and convexity analysis images (in the Examples and the like below, the same methods were employed). Moreover, the thickness of the coating film made of Block Copolymer (P-1) in the obtained master block was measured by use of a step measuring instrument (manufactured by Kosaka Seisakusho under the product name of "SURF-COATER ET-4000A"). As a result, the thickness of the coating film was 104 nm.

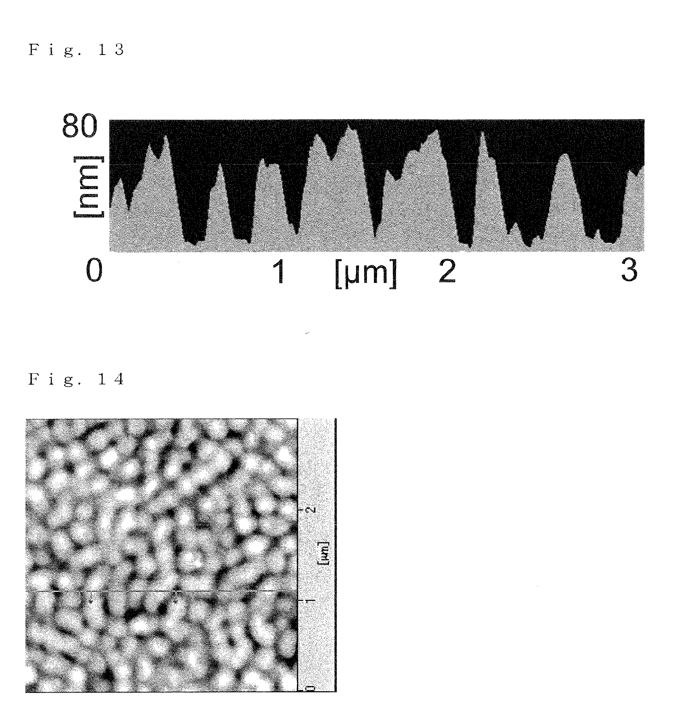

Next, the coating film of the obtained Master Block (M-1) was irradiated with ultraviolet rays at an irradiation intensity of 12 J/cm$^2$ by use of a high pressure mercury lamp, and then subjected to ultrasonic cleaning in acetic acid. Thus, First Master Block (M-2) subjected to an etching treatment by which PMMA was selectively removed was obtained. In addition, concavity and convexity analysis images of the thus obtained Master Block (M-2) were obtained by measurement using the above-described measuring methods for a concavity and convexity analysis image and a Fourier-transformed image. Fig. 12 shows the obtained concavity and convexity analysis image, and Fig. 13 shows the obtained cross-sectional concavity and convexity analysis image. As is apparent from the results shown in Figs. 9, 10, 12 and 13, it was found that the etching treatment deepened the shape of the concavities and convexities formed on the surface. Note that the average pitch of the concavities and convexities of Master Block (M-2) was 280 nm, and the average height of the concavities and convexities thereof was 55 nm.

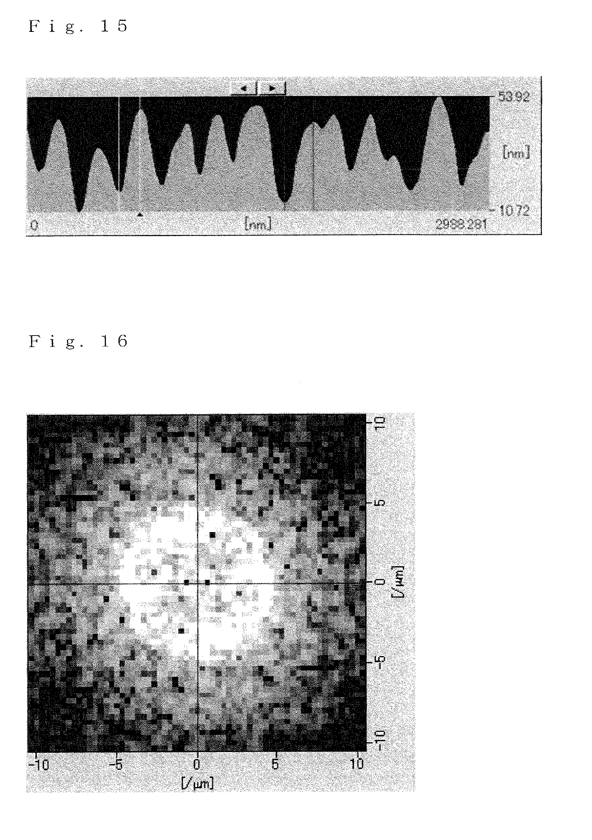

Subsequently, a silicone-based polymer [a resin composition of a mixture of 90% by mass of a silicone rubber (manufactured by Wacker Chemie AG under the product name of "Elastosil RT601") and 10% by mass of a curing agent] was applied onto the obtained Master Block (M-2) by a dropping method, then cured by being heated at 50°C for 1 hour, and thereafter detached from Master Block (M-2). Thus, Second Master Block (M-3) was obtained. Concavity and convexity analysis images and a Fourier-transformed image of the thus obtained Master Block (M-3) were obtained by measurement using the above-described measuring methods for a concavity and convexity analysis image and a Fourier-transformed image. Fig. 14 shows the obtained concavity and convexity analysis image, Fig. 15 shows the obtained cross-sectional concavity and convexity analysis image, and Fig. 16 shows the obtained Fourier-transformed image. As is apparent from the Fourier-transformed image shown in Fig. 16, it was found that the Fourier-transformed image showed a circular pattern substantially centered at an origin at which an absolute value of wavenumber was 0 $\mu m^{-1}$, and the circular pattern was such that 90% or more of all bright spots constituting the Fourier-transformed image were present in a region where an absolute value of wavenumber was within a range from 0.5 to 10 $\mu m^{-1}$. Note that the average pitch of the concavities and convexities of Second Master Block (M-3) was 280 nm, and the average height of the concavities and convexities thereof was 25 nm.

<Step of Manufacturing Solar Cell>

First, a glass substrate (manufactured by Matsunami Glass Ind. , Ltd. , under the product name of "Micro slide glass") and an ultraviolet ray-curable resin (Tg=226°C, viscosity=206 Cp, pencil hardness during curing=5H to 7H) mainly containing pentaerythritol triacrylate and pentaerythritol tetraacrylate were prepared. Then, the curable resin was applied onto the glass substrate to an application thickness of 15.0 $\mu m$. Thereafter, the curable resin was cured by irradiation with ultraviolet rays (energydensity: 6000 mJ/cm$^2$), with Master Block (M-3) being pressed thereto. Then, Master Block (M-3) was detached from the cured resin layer, and thereby the cured resin layer (thickness: 13.5 $\mu m$) having concavities and convexities formed thereon was stacked on the glass substrate. Thus, a first stack (glass substrate/cured resin layer) was obtained.

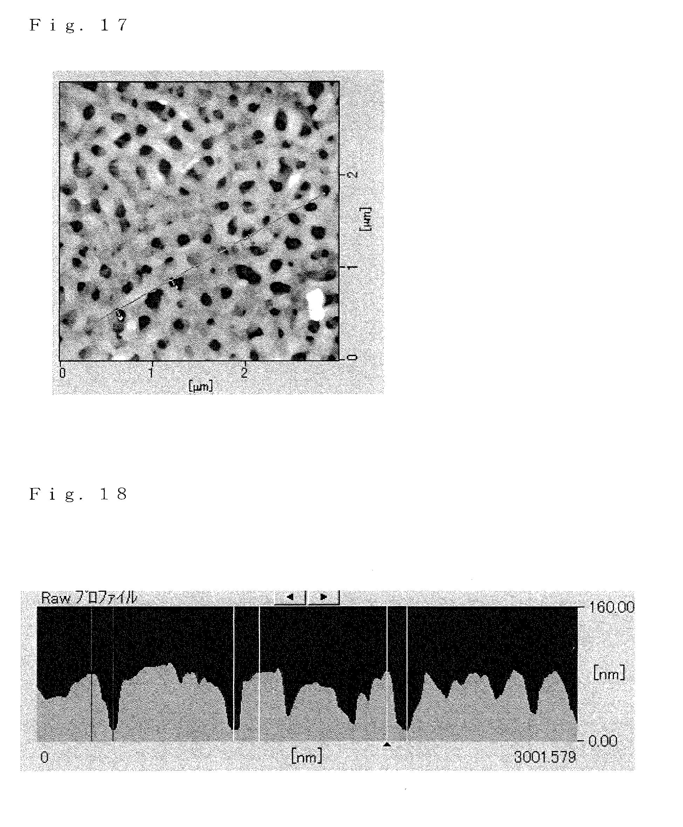

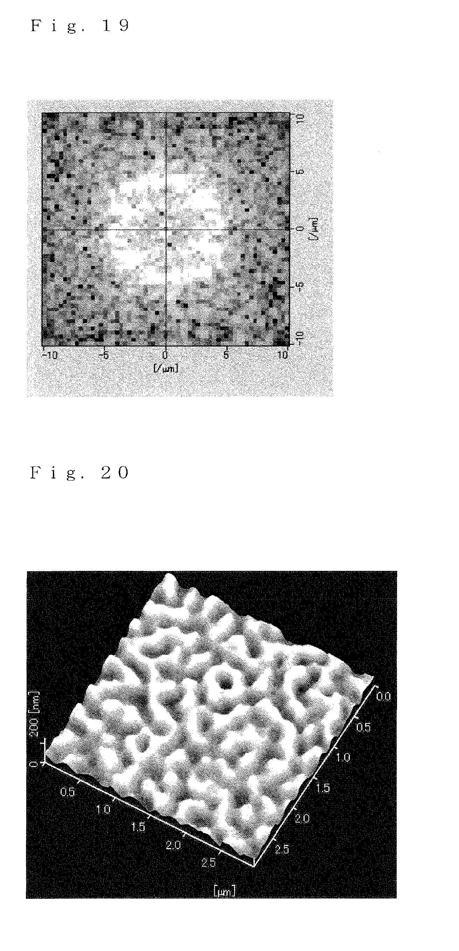

Concavity and convexity analysis images and a Fourier-transformed image of the cured resin layer in the thus obtained first stack were obtained by measurement using the above-described measuring methods for a concavity and convexity analysis image and a Fourier-transformed image. Fig. 17 shows a concavity and convexity analysis image of the obtained cured resin layer, Fig. 18 shows a cross-sectional concavity and convexity analysis image thereof, and Fig. 19 shows a Fourier-transformed image thereof. As is apparent from the Fourier-transformed image shown in Fig. 19, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 10 $\mu$m$^{-1}$. Note that the average pitch of the concavities and convexities of the curable resin was 280 nm, and the average height of the concavities and convexities thereof was 35 nm.

Subsequently, a transparent electroconductive layer (transparent electrode) made of a material (AZO), which was zinc oxide (ZnO) doped with aluminum (Al), was stacked by a DC magnetron sputtering method on the surface (the surface on which the shape of the concavities and convexities was formed) of the cured resin layer of the obtained first stack. Here, the transparent electroconductive layer had such a shape that the shape of the concavities and convexities formed on the surface of the cured resin layer was maintained. Thus, a transparent electroconductive substrate for a solar cell was obtained. Note that the transparent electroconductive layer was a layer formed to a layer thickness of 500 nm by the DC magnetron sputtering method in which AZO (a sputtering target of ZnO doped with 1% by weight of $Al_2O_3$) was used as a raw material, and such a condition was employed that the temperature of the first stack was 200°C.

Next, a p-type amorphous silicon layer, an i-type amorphous silicon layer, and an n-type silicon layer were stacked in this order on the transparent electroconductive layer of the transparent electroconductive substrate by employing a plasma CVD method, and thereby a semiconductor layer (photoelectric conversion layer) was stacked on the transparent electroconductive layer. Thus, a second stack (transparent electroconductive substrate [glass substrate/ cured resin layer/transparent electroconductive layer]/semiconductor layer) was obtained. Note that the p-type amorphous silicon layer was a layer formed by a plasma CVD method to a layer thickness of 15 nm under a condition that the temperature of the transparent electroconductive substrate was 180°C, by controlling a first raw material gas containing $SiH_4$ gas (25% by volume), $H_2$ gas (75% by volume), and $B_2H_6$ gas (0.01% by volume) such that a degree of vacuum of 22 Pa was obtained in the reaction chamber, and by employing a condition of a plasma discharge power of 20 W. Moreover, the i-type amorphous silicon layer was a layer formed by a plasma CVD method to a layer thickness of 350 nm under a condition that the temperature of the transparent electroconductive substrate was 180°C, by controlling a second raw material gas containing $SiH_4$ gas (30% by volume) and $H_2$ gas (70% by volume) such that a degree of vacuum of 30 Pa was obtained in the reaction chamber, and by employing a condition of a plasma discharge power of 30 W. Moreover, the n-type silicon layer was a layer formed by a plasma CVD method to a layer thickness of 30 nm under a condition that the temperature of the transparent electroconductive substrate was 180°C, by controlling a third raw material gas containing $SiH_4$ gas (10% by volume), $H_2$ gas (90% by volume), and $PH_3$ gas (0.01% by volume) such that a degree of vacuum of 28 Pa was obtained in the reaction chamber, and by employing a condition of a plasma discharge power of 25 W.

Subsequently, a counter electrode electroconductive layer made of zinc oxide was stacked on the second stack (glass substrate/cured resin layer/transparent electroconductive layer/semiconductor layer) by employing a DC magnetron sputtering method. Thus, a third stack (glass substrate/cured resin layer/transparent electroconductive layer/ semiconductor layer/counter electrode electroconductive layer) was obtained. Note that the counter electrode electroconductive layer was a layer formed by a sputtering method to a layer thickness of 50 nm by using zinc oxide as a raw material and by employing a condition that the temperature of the second stack was 200°C.

Next, a reflection layer (back surface electrode) made of silver was stacked on the counter electrode electroconductive layer of the third stack (glass substrate/cured resin layer/transparent electroconductive layer/semiconductor layer/counter electrode electroconductive layer) by employing an electron beam deposition method. Thus, a solar cell (glass substrate/cured resin layer/transparent electroconductive layer/semiconductor layer/counter electrode electroconductive layer/reflection layer) was obtained. Note that the reflection layer was a layer formed by an electron beam deposition method to a layer thickness of 500 nm by using silver as a raw material, and by employing a condition that the temperature of the third stack was normal temperature (25°C).

Current-voltage characteristics of the solar cell obtained in Example 1 were measured by irradiating the solar cell with an AM 1.5 sunlight spectrum by using an AM 1.5 light source at a temperature of 25°C under an irradiation condition of 100 mW/cm$^2$. As a result, it was found that the photoelectric conversion efficiency was 1.10 times greater than that of a solar cell obtained in Comparative Example 1 to be described later. From the results of the measurement of the current-voltage characteristics, it was found that the solar cell obtained in Example 1 had a sufficiently high level of photoelectric conversion efficiency. These results are attributable to the fact that the shape of the concavities and convexities formed in the transparent electroconductive substrate exhibited a sufficiently high level of light confinement effect.

(Example 2)

A solar cell was obtained in the same manner as in Example 1, except that a shape of concavities and convexities was formed on a surface of a curable resin by using Master Block (M-7) obtained by employing the following manufacturing step instead of Master Block (M-3).

<Step of Manufacturing Master Block (M-7)>

In 10 g of toluene, 100 mg of Block Copolymer (P-1) was dissolved. Next, a toluene solution was obtained by adding Homopolymer (A) thereto at such a ratio that Homopolymer (A) was 25 parts by mass relative to 100 parts by mass of Block Copolymer (P-1). Then, this toluene solution was filtered through a membrane filter having a pore diameter of 0.45 $\mu$m. Thus, a block copolymer solution was obtained. Subsequently, the thus obtained block copolymer solution was spin coated on a polyphenylene sulfide film (manufactured by Toray Industries, Inc.) serving as a base member at a spin speed of 800 rpm. Then, the coating film was subjected to an annealing treatment by being heated in an oven of 170°C for 5 hours. Thus, First Master Block (M-4) having concavities and convexities formed thereon was obtained. Concavity and convexity analysis images of the obtained Master Block (M-4) were obtained by measurement using the above-described measurement method for a concavity and convexity analysis image. As a result, it was found that concavities and convexities due to micro phase separation were formed on the surface of Master Block (M-4).

Next, the coating film of the obtained Master Block (M-4) was irradiated with ultraviolet rays at an irradiation intensity of 12 J/cm$^2$ by use of a high pressure mercury lamp, and then immersed in acetone. Thus, Second Master Block (M-5) subjected to an etching treatment by which PMMA and PEO were selectively removed was obtained. A concavity and convexity analysis image of the thus obtained Master Block (M-5) was obtained by measurement using the above-described measurement method for a concavity and convexity analysis image. As a result, it was found that concavities and convexities due to micro phase separation were formed on the surface of Master Block (M-5), and that the depth of the shape of the concavities and convexities was deeper than that of the shape of the concavities and convexities of Master Block (M-4).

Subsequently, a silicone-based polymer [a resin composition of a mixture of 90% by mass of a silicone rubber (manufactured by Wacker Chemie AG under the product name of "Elastosil RT601") and 10% by mass of a curing agent] was applied onto the obtained Master Block (M-5) by a dropping method, then cured by being heated at 50°C for 1 hour, and thereafter detached from Master Block (M-5). Thus, Second Master Block (M-6) was obtained. A concavity and convexity analysis image of the obtained Master Block (M-6) was obtained by measurement using the above-described measurement method for a concavity and convexity analysis image. As a result, it was found that concavities and convexities due to micro phase separation were formed on the surface of Master Block (M-6).

Subsequently, a PET substrate (manufactured by Toyobo Co., Ltd., under the product name of "COSMOSHINE A4100") and a fluorine-containing UV curable resin were prepared. The curable resin was applied onto the PET substrate, and then the fluorine-containing UV curable resin was cured by irradiation with ultraviolet rays at 600 mJ/cm$^2$, with the obtained Master Block (M-6) being pressed thereto. After that, Master Block (M-6) was detached from the cured resin layer. Thus, Fourth Master Block (M-7) on the PET substrate was obtained. A concavity and convexity analysis image of the obtained Master Block (M-7) was obtained by measurement using the above-described measurement method for a concavity and convexity analysis image. As a result, it was found that concavities and convexities due to micro phase separation were formed on the surface of Master Block (M-7).

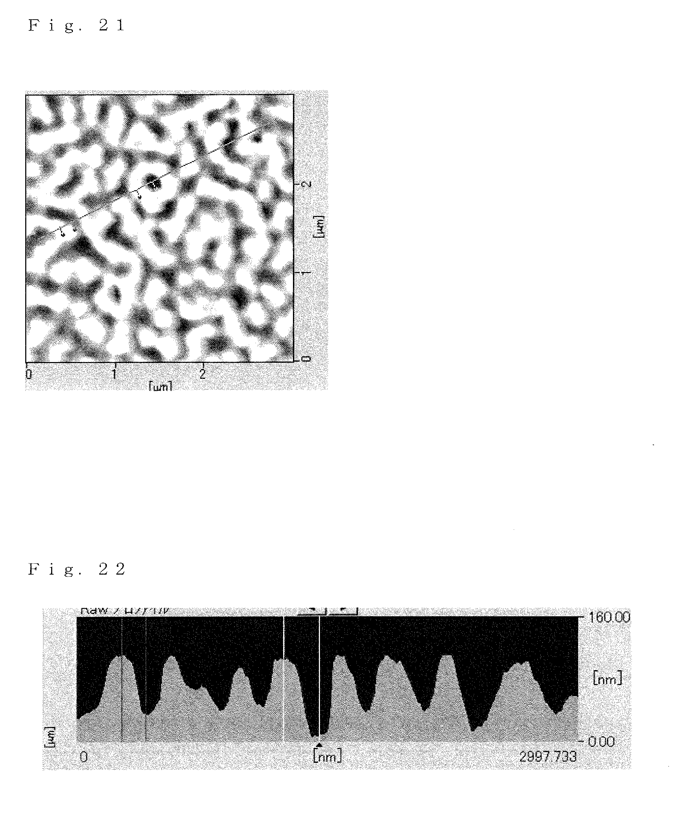

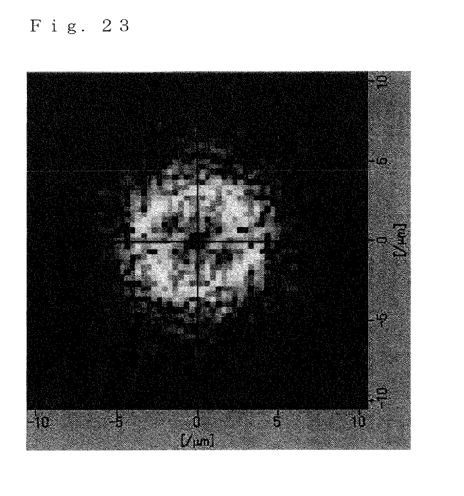

Concavity and convexity analysis images and a Fourier-transformed image of a cured resin layer in a first stack (glass substrate/cured resin layer: a stack obtained by applying a curable resin onto a glass substrate, and then curing the curable resin by irradiating the curable resin with ultraviolet rays at 600 mJ/cm$^2$, with Master Block (M-7) being pressed to the obtained coating film) formed by using the thus obtained Master Block (M-7) were obtained by measurement using the above-described measuring methods for a concavity and convexity analysis image and a Fourier-transformed image. Figs. 20 and 21 show concavity and convexity analysis images of the thus obtained cured resin layer, Fig. 22 shows a cross-sectional concavity and convexity analysis image thereof, and Fig. 23 shows a Fourier-transformed image thereof. As is apparent from the Fourier-transformed image shown in Fig. 23, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 5 $\mu$m$^{-1}$. Note that the average pitch of the concavities and convexities of the cured resin layer was 250 nm, and the average height of the concavities and convexities thereof was 80 nm.

(Example 3)

A solar cell was obtained in the same manner as in Example 1, except that a shape of concavities and convexities was formed on a surface of a curable resin by using Master Block (M-9) obtained by employing the following manufacturing step instead of Master Block (M-3).

<Step of Manufacturing Master Block (M-9)>

Block Copolymer (P-1) and Homopolymer (A) were dissolved in toluene at such a ratio that Homopolymer (A) was 25 parts by mass relative to 100 parts by mass of Block Copolymer (P-1). Thus, a toluene solution was obtained in which the concentration of the total amount of Block Copolymer (P-1) and Homopolymer (A) was 1.2% by mass. Then, this toluene solution was filtered through a membrane filter having a pore diameter of 0.45 $\mu$m. Thus, a block copolymer solution was obtained. Subsequently, the thus obtained block copolymer solution was spin coated on a polyphenylene sulfide substrate (manufactured by Toray Industries, Inc.) at a spin speed of 800 rpm. Thus, a coating film was obtained. Next, the coating film was subjected to an annealing treatment by being heated in a vacuum oven of 170°C for 8 hours. Thus, First Master Block (M-8) having concavities and convexities due to micro phase separation formed on a surface thereof was obtained. The thus obtained Master Block (M-8) was measured by the above-described measurement method for a concavity and convexity analysis image. As a result, it was found that concavities and convexities due to micro phase separation were formed on the surface of Master Block (M-8).

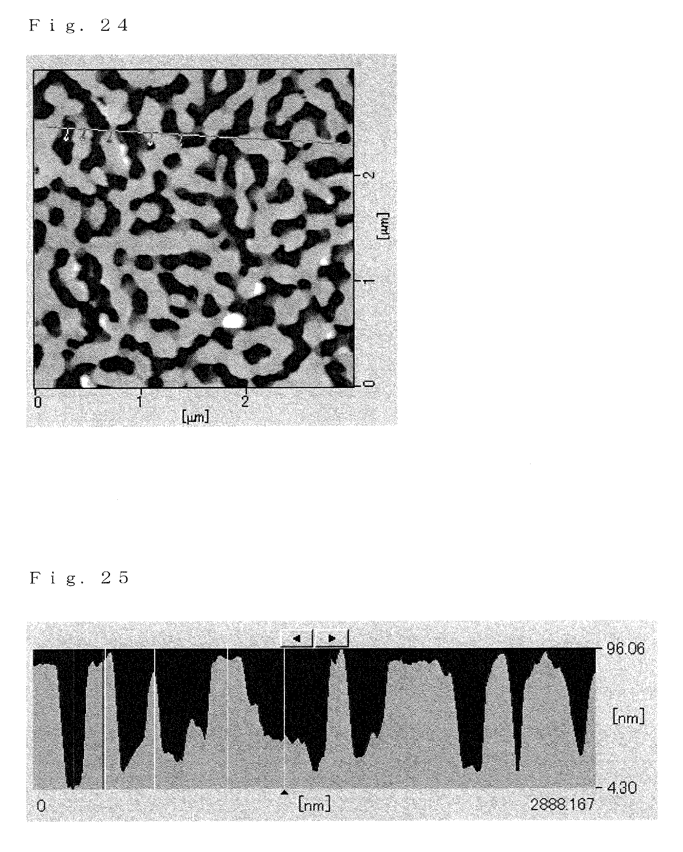

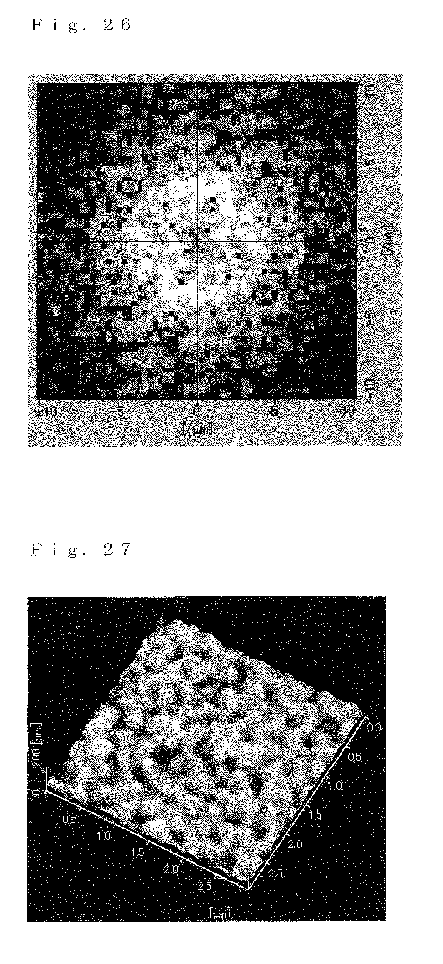

Subsequently, the coating film of the obtained Master Block (M-8) was irradiated with ultraviolet rays at an irradiation intensity of 12 J/cm$^2$ by use of a high pressure mercury lamp, and then subjected to ultrasonic cleaning in acetic acid. Thus, First Master Block (M-9) subjected to an etching treatment by which PMMA and PEO were selectively removed was obtained. Concavity and convexity analysis images and a Fourier-transformed image of the obtained Master Block (M-9) were obtained by measurement using the above-described measuring methods for a concavity and convexity analysis image and a Fourier-transformed image. Fig. 24 shows the obtained concavity and convexity analysis image, Fig. 25 shows the obtained cross-sectional concavity and convexity analysis image, and Fig. 26 shows the obtained Fourier-transformed image. As is apparent from the results shown in Figs. 24 and 25, it was found that concavities and convexities due to micro phase separation were formed on the surface of Master Block (M-9). Moreover, as is apparent from the results shown in Figs. 24 and 25, it was found that the use of polyethylene oxide (Homopolymer (A)) resulted in more vertical wall faces of the concave portions, and sufficiently increased the orientation in the vertical direction. In addition, from the results shown in Figs. 24 and 25, it was found that a master block having a sufficiently deep shape of the concavities and convexities was obtained. Moreover, as is apparent from the Fourier-transformed image shown in Fig. 26, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 10 $\mu$m$^{-1}$. Note that the thickness of the coating film made of Block Copolymer (P-1) in the obtained Master Block (M-9) was measured by use of a step measuring instrument (manufactured by Kosaka Seisakusho under the product name of "SURF-COATER ET-4000A"). As a result, the thickness of the coating film was 115 nm. In addition, the average pitch of the concavities and convexities of Master Block (M-9) was 280 nm, and the average height of the concavities and convexities thereof was 98 nm.

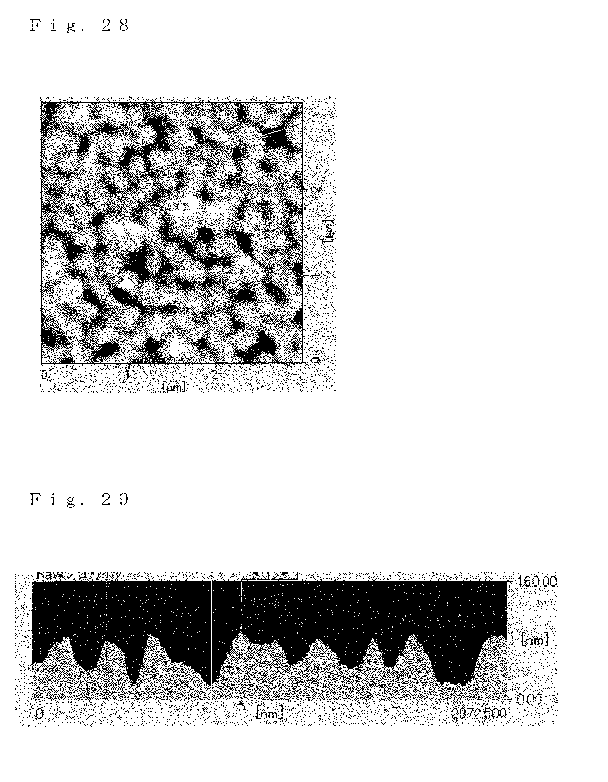

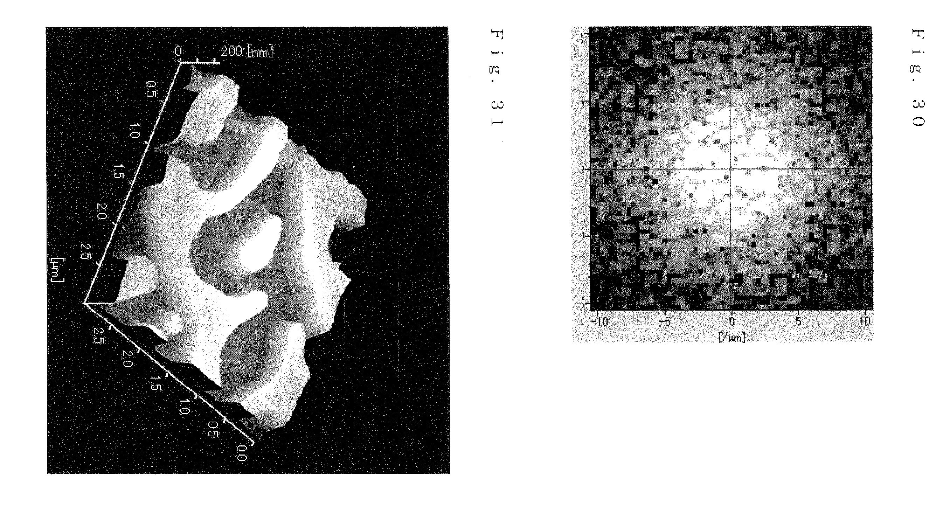

Concavity and convexity analysis images and a Fourier-transformed image of a cured resin layer in a first stack (glass substrate/cured resin layer) formed by using the thus obtained Master Block (M-9) were obtained by measurement using the above-described measuring methods for a concavity and convexity analysis image and a Fourier-transformed image. Figs. 27 and 28 show the obtained concavity and convexity analysis images, Fig. 29 shows the obtained cross-sectional concavity and convexity analysis image, and Fig. 30 shows the obtained Fourier-transformed image. As is apparent from the Fourier-transformed image shown in Fig. 30, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 10 $\mu$m$^{-1}$. Note that the average pitch of the concavities and convexities of the cured resin layer was 253 nm, and the average height of the concavities and convexities thereof was 75 nm.

(Example 4)

A solar cell was obtained in the same manner as in Example 1, except that a shape of concavities and convexities was formed on a surface of a curable resin by using Master Block (M-11) obtained by employing the following manufacturing step instead of Master Block (M-3).

<Step of Manufacturing Master Block (M-11)>

First, a 0.1% by mass solution of a random copolymer in toluene was spin coated on a silicon wafer, and then subjected to a heat treatment at a temperature of 170°C for 24 hours. Thus, a base member was obtained. Next, Block Copolymer (P-1) and Homopolymer (A) were dissolved in toluene at a such a ratio that Homopolymer (A) was 25 parts by mass relative to 100 parts by mass of Block Copolymer (P-1). Thus, a toluene solution was obtained in which the concentration of the total amount of Block Copolymer (P-1) and Homopolymer (A) was 1.5% by mass. Then, this toluene solution was filtered through a membrane filter having a pore diameter of 0.45 $\mu$m. Thus, a block copolymer solution was obtained. Subsequently, the thus obtained block copolymer solution was spin coated on the base member at a spin speed of 800 rpm. Thus, a coating film was obtained. Next, the coating film was dried on a hot plate of 55°C for 10 minutes, and then subjected to an annealing treatment by being heated in a vacuum oven of 190°C for 12 hours. Thus, First Master Block (M-10) having concavities and convexities due to micro phase separation formed on a surface thereof was obtained. The thus obtained Master Block (M-10) was measured by the above-described measurement method for a concavity and convexity analysis image. As a result, it was found that concavities and convexities due to micro phase separation were formed on a surface of Master Block (M-10).

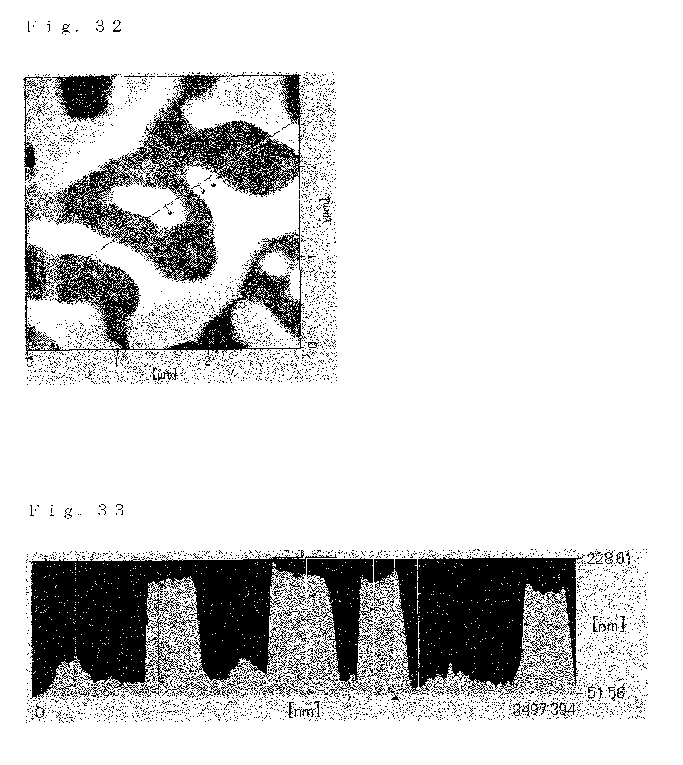

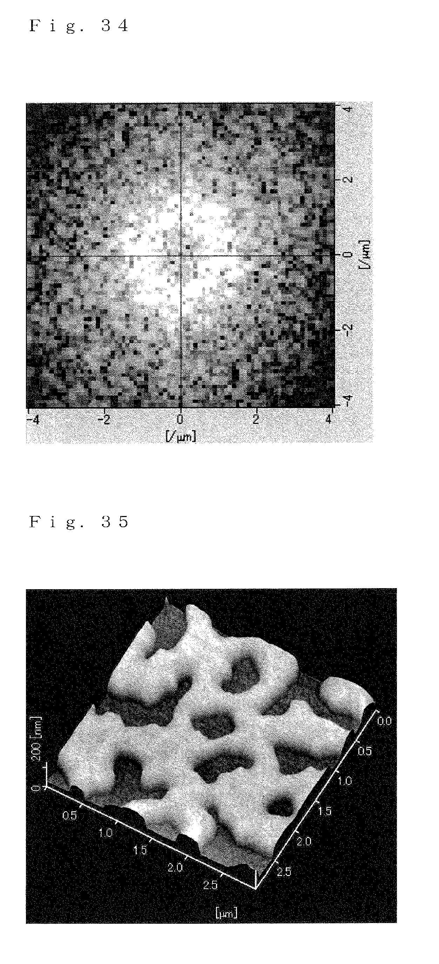

Subsequently, the coating film of the obtained Master Block (M-10) was irradiated with ultraviolet rays at an irradiation intensity of 12 J/cm$^2$ by use of a high pressure mercury lamp, and then subjected to ultrasonic cleaning in acetone. Thus, First Master Block (M-11) subjected to an etching treatment by which PMMA and PEO were selectively removed was obtained. Concavity and convexity analysis images and a Fourier-transformed image were obtained by measuring the shape of concavities and convexities formed on a surface of the obtained Master Block (M-11) by the above-described measuring methods for a concavity and convexity analysis image and a Fourier-transformed image. Figs. 31 and 32 show the obtained concavity and convexity analysis images, Fig. 33 shows the obtained cross-sectional concavity and convexity analysis image, and Fig. 34 shows the obtained Fourier-transformed image. As is apparent from the results shown in Figs. 31 to 33, it was found that concavities and convexities due to micro phase separation were formed on the surface of Master Block (M-11). Moreover, as is apparent from the results shown in Figs. 31 to 33, the use of polyethylene oxide (Homopolymer (A)) resulted in more vertical wall faces of the concave portions, and sufficiently increased the orientation in the vertical direction. In addition, as is apparent from the results shown in Figs. 31 to 33, it was found that the use of polyethylene oxide (Homopolymer (A)) made it possible to obtain a master block having a sufficiently deep shape of the concavities and convexities. Moreover, as is apparent from the Fourier-transformed image shown in Fig. 34, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 10 $\mu$m$^{-1}$. Note that the thickness of the coating film made of Block Copolymer (P-1) in the obtained Master Block (M-11) was measured by use of a step measuring instrument (manufactured by Kosaka Seisakusho under the product name of "SURF-COATER ET-4000A"). As a result, the thickness of the coating film was 180 nm. In addition, the average pitch of the concavities and convexities of Master Block (M-11) was 780 nm, and the average height of the concavities and convexities thereof was 155 nm.

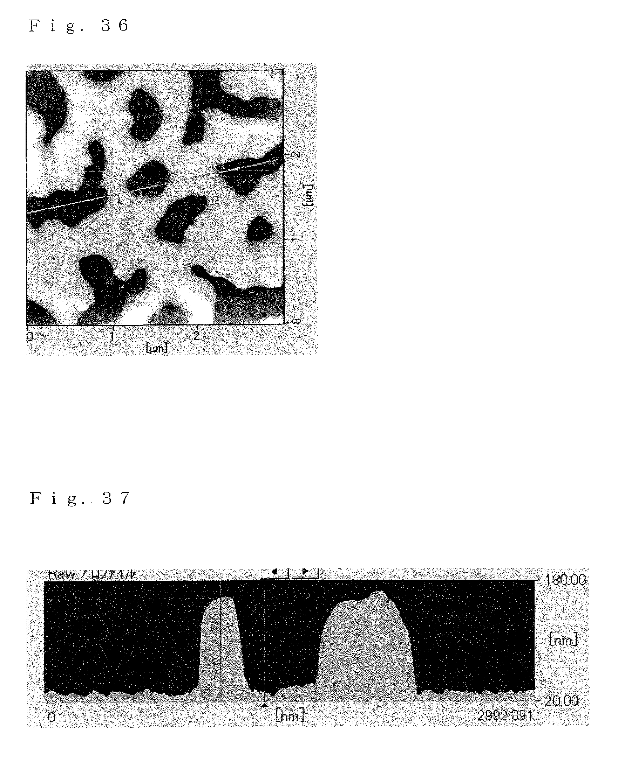

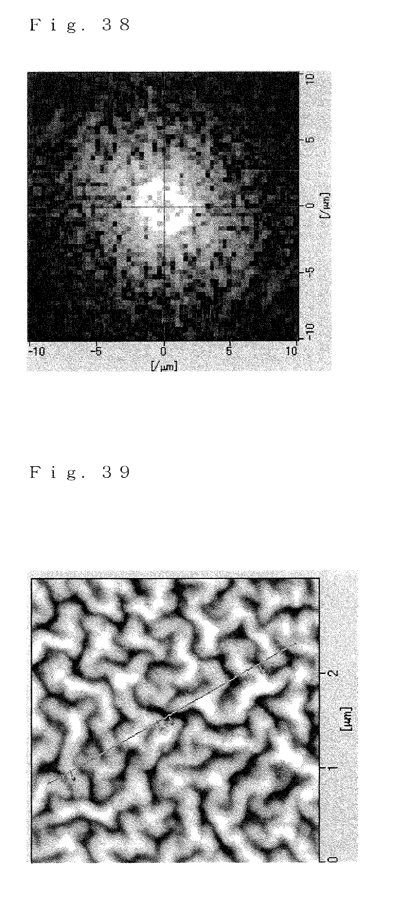

Concavity and convexity analysis images and a Fourier-transformed image of a cured resin layer in a first stack (glass substrate/cured resin layer) formed by using the thus obtained Master Block (M-11) were obtained by measurement using the above-described measuring methods for a concavity and convexity analysis image and a Fourier-transformed image. Figs. 35 and 36 show the obtained concavity and convexity analysis images, Fig. 37 shows the obtained cross-sectional concavity and convexity analysis image, and Fig. 38 shows the obtained Fourier-transformed image. As is apparent from the Fourier-transformed image shown in Fig. 38, it was found that the Fourier-transformed image showed an annular pattern substantially centered at an origin at which an absolute value of wavenumber was 0 $\mu$m$^{-1}$, and the annular pattern was such that 90% or more of all bright spots constituting the Fourier-transformed image were present in a region where an absolute value of wavenumber was within a range from 0.5 to 10 $\mu$m$^{-1}$. Note that the average pitch of the concavities and convexities of the cured resin layer was 770 nm, and the average height of the concavities and convexities thereof was 135 nm.

(Example 5)

A solar cell was obtained in the same manner as in Example 1, except that a shape of concavities and convexities was formed on a surface of a curable resin by using Master Block (M-14) obtained by employing the following manufacturing step instead of Master Block (M-3).

<Step of Manufacturing Master Block (M-14)>

First, a silicone-based polymer [a resin composition of a mixture of 90% bymass of a silicone rubber (manufactured by Wacker Chemie AG under the product name of "Elastosil RT601") and 10% by mass of a curing agent] was applied onto a glass substrate (size: 20 mm×12 mm) by a spin coating method, and then cured by being heated at 100°C for 1 hour. Thus, a silicone-based polymer film was formed.

Next, an aluminum vapor-deposition film (thickness : 10 nm) was formed on the silicone-based polymer film by a vapor deposition method under conditions that the temperature was 100°C and the pressure was 1×10$^{-3}$ Pa, and then cooled to room temperature (25°C) over 30 minutes. Then, the pressure was returned to atmospheric pressure (1.013×10$^5$ Pa). As a result, concavities and convexities were formed on a surface of the aluminum vapor-deposition film formed on the silicone-based polymer film. Subsequently, a silicone-based polymer [a resin composition of a mixture of 90% by mass of a silicone rubber (manufactured by Wacker Chemie AG under the product name of "Elastosil RT601") and 10% by mass of a curing agent] was applied onto the aluminum vapor-deposition film by a dropping method, then cured by being heated at 100°C for 1 hour, and then detached from the aluminum vapor-deposition film. Thus, Master Block (M-12) was obtained.

Then, an aluminum vapor-deposition film (thickness: 10 nm) was formed by a vapor deposition under conditions that the temperature was 100°C and the pressure was $1 \times 10^{-3}$ Pa on Master Block (M-12) having concavities and convexities formed on a surface thereof, and then cooled to room temperature (25°C) over 30 minutes. Then, the pressure was returned to atmospheric pressure ($1.013 \times 10^5$ Pa). As a result, concavities and convexities were formed on a surface of the aluminum vapor-deposition film formed on Master Block (M-12). Subsequently, a silicone-based polymer [a resin composition of a mixture of 90% by mass of a silicone rubber (manufactured by Wacker Chemie AG under the product name of "Elastosil RT601") and 10% by mass of a curing agent] was applied onto the aluminum vapor-deposition film by a dropping method, cured by being heated at 100°C for 1 hour, and then detached from the aluminum vapor-deposition film. Thus, Master Block (M-13) was obtained. Moreover, an aluminum vapor-deposition film (thickness: 10 nm) was formed by a vapor deposition under conditions that the temperature was 100°C and the pressure was $1 \times 10^{-3}$ Pa on Master Block (M-13) having concavities and convexities formed on a surface thereof, and then cooled to room temperature (25°C) over 30 minutes. Then, the pressure was returned to atmospheric pressure ($1.013 \times 10^5$ Pa). As a result, concavities and convexities were formed on the surface of the aluminum vapor-deposition film formed on Master Block (M-13). Subsequently, a silicone-based polymer [a resin composition of a mixture of 90% by mass of a silicone rubber (manufactured by Wacker Chemie AG under the product name of "Elastosil RT601") and 10% by mass of a curing agent] was applied onto the aluminum vapor-deposition film by a dropping method, cured by being heated at 100°C for 1 hour, and then detached from the aluminum vapor-deposition film. Thus, Master Block (M-14) was obtained.

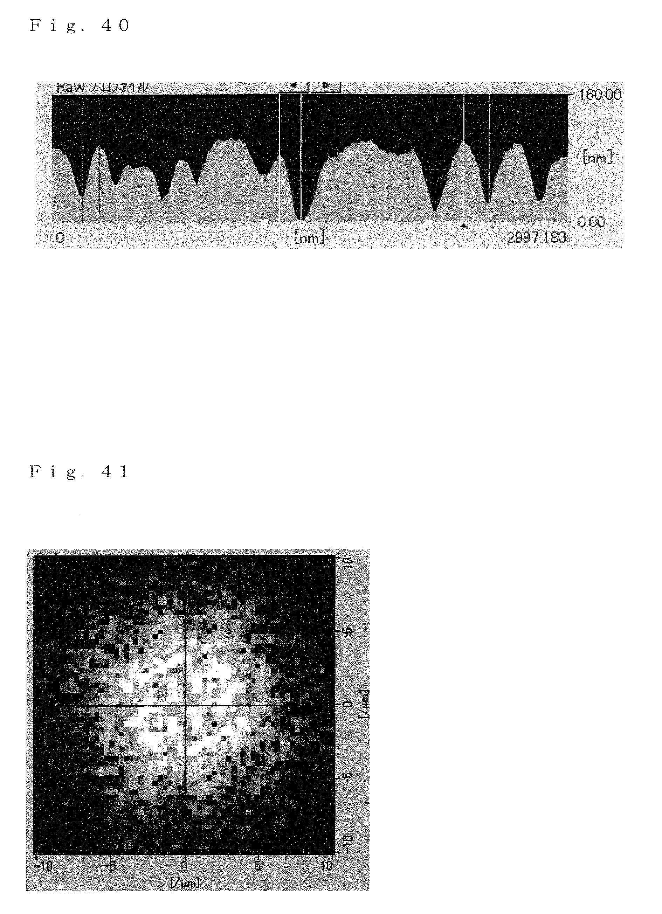

Concavity and convexity analysis images and a Fourier-transformed image of a cured resin layer in a first stack (glass substrate/cured resin layer) formed by using the thus obtained Master Block (M-14) were obtained by measurement using the above-described measuring methods for a concavity and convexity analysis image and a Fourier-transformed image. Fig. 39 shows a concavity and convexity analysis image of the obtained cured resin layer, Fig. 40 shows a cross-sectional concavity and convexity analysis image thereof, and Fig. 41 shows a Fourier-transformed image thereof. As is apparent from the Fourier-transformed image shown in Fig. 41, it was found that the Fourier-transformed image showed an annular pattern substantially centered at an origin at which an absolute value of wavenumber was 0 $\mu m^{-1}$, and the annular pattern was such that 90% or more of all bright spots constituting the Fourier-transformed image were present in a region where an absolute value of wavenumber was within a range from 0.5 to 8.0 $\mu m^{-1}$. Note that the average pitch of the concavities and convexities of the curable resin was 330 nm, and the average height of the concavities and convexities thereof was 75 nm.

(Comparative Example 1)

A solar cell was obtained in the same manner as in Example 1, except that no master block was manufactured, and that the step of manufacturing a first stack in the step of manufacturing a solar cell was replaced with the following step of manufacturing a first stack.

<Step of Manufacturing First Stack>

A glass substrate (manufactured by Matsunami Glass Ind., Ltd., under the product name of "Micro slide glass") and a curable resin (manufactured by Norland Optical Adhesive under the product name of "NOA 61") were prepared. The curable resin was applied onto the glass substrate, and then cured by irradiating the curable resin as it was with ultraviolet rays (energy density: 6000 mJ/cm$^2$). Thus, a first stack (glass substrate/cured resin layer) was obtained.

[Industrial Applicability]

As described above, according to the present invention, it is possible to provide a transparent electroconductive substrate for a solar cell, the substrate being capable of exhibiting a sufficiently excellent light confinement effect, and of providing a sufficiently high level of photoelectric conversion efficiency to a solar cell, when used as a transparent electroconductive substrate of a solar cell, as well as a method for manufacturing a transparent electroconductive substrate for a solar cell, the method being capable of efficiently manufacturing such a transparent electroconductive substrate for a solar cell, and a solar cell using the transparent electroconductive substrate. Accordingly, the transparent electroconductive substrate for a solar cell of the present invention can exhibit an excellent light confinement effect, and hence particularly useful as a substrate on a light incident surface of a thin-type solar cell, and the like.

[Reference Signs List]

10: transparent electroconductive substrate for a solar cell
11: transparent supporting substrate
12': coating film of curable resin
12: cured resin layer
13: transparent electroconductive layer
21: master block
22: base member
23': coating film of block copolymer in wet state
23: coating film of dried block copolymer
24': coating film of transfer material
24: master block made of cured transfer material

**Claims**

1. A transparent electroconductive substrate for a solar cell, comprising:

   a transparent supporting substrate;
   a transparent electroconductive layer; and
   a cured resin layer placed between the transparent supporting substrate and the transparent electroconductive layer, wherein
   concavities and convexities are formed on a surface of the cured resin layer, the surface facing the transparent electroconductive layer, and
   when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu$m$^{-1}$, and the circular or annular pattern is present within a region where an absolute value of wavenumber is within a range from 0.5 to 10 $\mu$m$^{-1}$.

2. The transparent electroconductive substrate for a solar cell according to claim 1, wherein an average height of the concavities and convexities formed on the surface of the cured resin layer, the surface facing the transparent electroconductive layer, is 5 to 200 nm.

3. The transparent electroconductive substrate for a solar cell according to claim 1 or 2, wherein an average pitch of the concavities and convexities formed on the surface of the cured resin layer, the surface facing the transparent electroconductive layer, is within a range from 100 to 2000 nm.

4. The transparent electroconductive substrate for a solar cell according to any one of claims 1 to 3, wherein the cured resin layer is made of an acrylic resin.

5. A method for manufacturing a transparent electroconductive substrate for a solar cell, comprising the steps of:

   applying a curable resin onto a transparent supporting substrate, then curing the curable resin with a master block being pressed thereto, and thereafter detaching the master block, thereby stacking, on the transparent supporting substrate, a cured resin layer having concavities and convexities formed thereon; and
   stacking, on the cured resin layer, a transparent electroconductive layer having such a shape that the shape of the concavities and convexities formed on a surface of the cured resin layer is maintained, thereby obtaining a transparent electroconductive substrate for a solar cell, the transparent electroconductive substrate comprising the transparent supporting substrate, the cured resin layer, and the transparent electroconductive layer, wherein the master block is obtained by a method comprising the steps of:

   applying a block copolymer solution comprising a block copolymer and a solvent onto a base member, the block copolymer having a first polymer segment made of a first homopolymer and a second polymer segment made of a second homopolymer having a solubility parameter which is higher than a solubility parameter of the first homopolymer by 0.1 to 10 $(cal/cm^3)^{1/2}$, and satisfying all the following requirements (i) to (iii):

(i) a number average molecular weight is 500000 or more,
(ii) a molecular weight distribution (Mw/Mn) is 1.5 or less, and
(iii) a volume ratio between the first polymer segment and the second polymer segment (the first polymer segment:the second polymer segment) is 3:7 to 7:3; and

forming a micro phase separation structure of the block copolymer by drying a coating film on the base member, thereby obtaining a first master block having concavities and convexities formed on a surface thereof.

6. The method for manufacturing a transparent electroconductive substrate for a solar cell according to claim 5, wherein in the step of obtaining the first master block, the dried coating film is heated at a temperature higher than a glass transition temperature of the block copolymer.

7. The method for manufacturing a transparent electroconductive substrate for a solar cell according to claim 5 or 6, wherein
in the step of obtaining the first master block, the dried coating film is subjected to an etching treatment.

8. The method for manufacturing a transparent electroconductive substrate for a solar cell according to any one of claims 5 to 7, further comprising
a step of attaching a transfer material onto the first master block, then curing the transfer material, and thereafter detaching the transfer material from the first master block, thereby obtaining a second master block having concavities and convexities formed on a surface thereof.

9. The method for manufacturing a transparent electroconductive substrate for a solar cell according to any one of claims 5 to 8, wherein
a combination of the first homopolymer and the second homopolymer in the block copolymer is any of a combination of a styrene-based polymer and a polyalkyl methacrylate, a combination of a styrene-based polymer and polyethylene oxide, a combination of a styrene-based polymer and polyisoprene, and a combination of a styrene-based polymer and polybutadiene.

10. The method for manufacturing a transparent electroconductive substrate for a solar cell according to any one of claims 5 to 9, wherein
the block copolymer solution further comprises a different homopolymer from the first homopolymer and the second homopolymer in the block copolymer.

11. The method for manufacturing a transparent electroconductive substrate for a solar cell according to claim 10, wherein
the combination of the first homopolymer and the second homopolymer in the block copolymer is a combination of polystyrene and polymethyl methacrylate, and
the different homopolymer is a polyalkylene oxide.

12. A solar cell comprising:

a transparent electroconductive substrate;
a counter electrode electroconductive layer; and
a semiconductor layer placed between the transparent electroconductive substrate and the counter electrode electroconductive layer, wherein
the transparent electroconductive substrate comprises:

a transparent supporting substrate;
a transparent electroconductive layer; and
a cured resin layer placed between the transparent supporting substrate and the transparent electroconductive layer, concavities and convexities are formed on a surface of the cured resin layer, the surface facing the transparent electroconductive layer, and
when a Fourier-transformed image is obtained by performing two-dimensional fast Fourier transform processing on a concavity and convexity analysis image obtained by analyzing a shape of the concavities and convexities by use of an atomic force microscope, the Fourier-transformed image shows a circular or annular pattern substantially centered at an origin at which an absolute value of wavenumber is 0 $\mu m^{-1}$, and the circular or annular pattern is present within a region where an absolute value of wavenumber is within a range from 0.5 to 10 $\mu m^{-1}$.

13. The solar cell according to claim 12, wherein
an average height of the concavities and convexities formed on the surface of the cured resin layer, the surface facing the transparent electroconductive layer, is 5 to 200 nm.

14. The solar cell according to claim 12 or 13, wherein
an average pitch of the concavities and convexities formed on the surface of the cured resin layer, the surface facing the transparent electroconductive layer, is within a range from 100 to 2000 nm.

15. The solar cell according to any one of claims 12 to 14, wherein
the cured resin layer is made of an acrylic resin.

F i g . 1

1 3

1 2

1 1

1 0

F i g . 2

2 1

1 2 '

1 1

F i g . 3

2 1

1 2 '

1 1

F i g . 4

2 1

1 2

1 1

F i g . 5

2 3 '

2 2

F i g . 6

2 3

2 1

2 2

Fig. 7

24'

23
22
21

Fig. 8

24

23
22
21

F i g . 9

3 μm

F i g . 1 0

Fig. 11

Fig. 12

3 μm

Fig. 13

Fig. 14

Ｆｉｇ．１５

Ｆｉｇ．１６

Ｆｉｇ．１７

Ｆｉｇ．１８

Fig. 19

Fig. 20

Ｆｉｇ．２１

Ｆｉｇ．２２

Fig. 2 3

Ｆ ｉ ｇ ． ２ ４

Ｆ ｉ ｇ ． ２ ５

Fig. 26

Fig. 27

Fig. 28

Fig. 29

Fig. 30

Fig. 31

Fig. 32

Fig. 33

F i g. 3 4

F i g. 3 5

Ｆｉｇ．３６

Ｆｉｇ．３７

Ｆ ｉ ｇ ． ３ ８

Ｆ ｉ ｇ ． ３ ９

Fig. 40

Fig. 41

**INTERNATIONAL SEARCH REPORT**

| International application No. |
| --- |
| PCT/JP2011/055118 |

A. CLASSIFICATION OF SUBJECT MATTER
*H01L31/04*(2006.01)i, *B32B3/30*(2006.01)i, *B32B27/00*(2006.01)i, *B32B27/30* (2006.01)i

According to International Patent Classification (IPC) or to both national classification and IPC

B. FIELDS SEARCHED

Minimum documentation searched (classification system followed by classification symbols)
H01L31/04-31/078, B32B3/30, B32B27/00, B32B27/30

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
JSTPlus(JDreamII), JST7580(JDreamII)

C. DOCUMENTS CONSIDERED TO BE RELEVANT

| Category* | Citation of document, with indication, where appropriate, of the relevant passages | Relevant to claim No. |
| --- | --- | --- |
| A | WO 2009/119174 A1 (The Nippon Synthetic Chemical Industry Co., Ltd.), 01 October 2009 (01.10.2009), paragraphs [0018] to [0121]; fig. 1 to 3 & JP 2009-260270 A & EP 2261998 A | 1-15 |
| A | JP 2005-142358 A (Sharp Corp.), 02 June 2005 (02.06.2005), paragraphs [0025] to [0034]; fig. 1 to 2 (Family: none) | 1-4,12-15 |
| A | JP 2005-216959 A (Mitsubishi Heavy Industries, Ltd.), 11 August 2005 (11.08.2005), paragraphs [0012], [0017]; fig. 1 (Family: none) | 1-4,12-15 |

| ☒ Further documents are listed in the continuation of Box C. | ☐ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 25 May, 2011 (25.05.11) | 07 June, 2011 (07.06.11) |

| Name and mailing address of the ISA/ Japanese Patent Office | Authorized officer |
| --- | --- |
| Facsimile No. | Telephone No. |

Form PCT/ISA/210 (second sheet) (July 2009)

## INTERNATIONAL SEARCH REPORT

International application No.

PCT/JP2011/055118

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-298084 A  (TDK Corp.),<br>17 October 2003 (17.10.2003),<br>paragraphs [0021] to [0046]; fig. 1 to 5<br>(Family: none) | 1-15 |
| A | JP 2001-151834 A  (Toshiba Corp.),<br>05 June 2001 (05.06.2001),<br>paragraphs [0001], [0047] to [0165]; fig. 1<br>& US 6565763 B1 | 5-11 |
| A | JP 2004-124088 A  (The Circle for the Promotion<br>of Science and Engineering),<br>22 April 2004 (22.04.2004),<br>paragraphs [0025] to [0056]<br>(Family: none) | 5-11 |
| A | JP 6-221838 A  (Fujitsu Ltd.),<br>12 August 1994 (12.08.1994),<br>paragraphs [0015] to [0043]; fig. 1 to 5<br>(Family: none) | 1-4 |
| P,A | A. Krasnov, Light scattering by textured<br>transparent electrodes for thin-film silicon<br>solar cells, SOLAR ENERGY MATERIALS & SOLAR<br>CELLS, 2010.05.20, Vol.94, pp.1648-1657 | 1-15 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004102677 A
- JP 2000183378 A
- JP HEI07122764 B
- JP 2000277763 A